(19) Europäisches Patentamt
European Patent Office
Office européen des brevets

(11) **EP 3 234 695 B1**

(12) **EUROPÄISCHE PATENTSCHRIFT**

(45) Veröffentlichungstag und Bekanntmachung des Hinweises auf die Patenterteilung:
**10.10.2018 Patentblatt 2018/41**

(21) Anmeldenummer: **15813340.5**

(22) Anmeldetag: **15.12.2015**

(51) Int Cl.:
**G03F 7/20** (2006.01)    **G02B 5/09** (2006.01)

(86) Internationale Anmeldenummer:
**PCT/EP2015/079829**

(87) Internationale Veröffentlichungsnummer:
**WO 2016/096878 (23.06.2016 Gazette 2016/25)**

(54) **SPIEGEL-EINRICHTUNG**

MIRROR DEVICE

ENSEMBLE MIROIRS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.12.2014 DE 102014226272**

(43) Veröffentlichungstag der Anmeldung:
**25.10.2017 Patentblatt 2017/43**

(73) Patentinhaber: **Carl Zeiss SMT GmbH**
**73447 Oberkochen (DE)**

(72) Erfinder:
• **SAROV, Yanko**
**73431 Aalen (DE)**

• **HOLZ, Markus**
**73431 Aalen (DE)**
• **HAACKER, Fabian**
**73434 Aalen (DE)**
• **WENGLER, Mark Christof**
**89522 Heidenheim an der Breenz (DE)**
• **HAUF, Markus**
**89075 Ulm (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
**DE-A1-102013 218 748    US-A1- 2002 096 647**

EP 3 234 695 B1

**Beschreibung**

Die Erfindung betrifft eine Spiegel-Einrichtung, insbesondere eine Spiegel-Einrichtung für eine EUV-Projektionsbelichtungsanlage. Außerdem betrifft die Erfindung eine Beleuchtungsoptik für eine Projektionsbelichtungsanlage, ein Beleuchtungssystem mit einer derartigen Beleuchtungsoptik und eine Projektionsbelichtungsanlage mit einer derartigen Beleuchtungsoptik. Schließlich betrifft die Erfindung ein Verfahren zur Herstellung eines mikro- oder nanostrukturierten Bauelements und ein verfahrensgemäß hergestelltes Bauelement.

Beispielsweise aus der WO 2009/100856 A1 ist ein Facettenspiegel für eine Projektionsbelichtungsanlage bekannt, welcher eine Vielzahl von individuell verlagerbaren Einzelspiegeln aufweist. Um die optische Qualität eine Projektionsbelichtungsanlage sicherzustellen, ist eine sehr präzise Positionierung der verlagerbaren Einzelspiegel notwendig.

DE102013218748 A1 offenbart eine Vielspiegelanordnung mit einer Vielzahl von Einzelspiegeln, wobei Mittel zur Verringerung eines strahlungsinduzierten Einflusses auf die Positionierung der Einzelspiegel beschrieben werden. In einem Ausführungsbeispiel ist ein Gitter vor den Einzelspiegeln angeordnet zur elektrostatischen Abschirmung der Einzelspiegel und der darunterliegenden Elektronik.

Der Erfindung liegt die Aufgabe zugrunde, eine Spiegel-Einrichtung, insbesondere eine Spiegel-Einrichtung für eine Projektionsbelichtungsanlage, zu verbessern. Diese Aufgabe wird durch eine Spiegel-Einrichtung mit mindestens einem Spiegel und mindestens zwei elektrisch leitfähigen Abschirm-Elementen gelöst, wobei die mindestens zwei elektrisch leitfähigen Abschirm-Elemente mit unterschiedlichen elektrischen Spannungen beaufschlagbar sind, und ein Mittel zur Erzeugung eines elektrischen Feldes Feldes in einem an die mindestens eine Seitenfläche und/oder die Rückseite angrenzenden Bereich bilden.

Erfindungsgemäß wurde erkannt, dass ein derartiges elektrisches Feld zur Abschirmung eines vorgegebenen Volumens gegen freie Ladungen dienen kann. Mittels der erfindungsgemäßen Abschirm-Elemente lässt sich insbesondere sicherstellen, dass ein Volumen hinter der Rückseite des Spiegels gegen freie Ladungen abgeschirmt ist. Es ist insbesondere möglich, sicherzustellen, dass sensitive Bauelemente, insbesondere Bauelemente, welche zur Steuerung der Verlagerung des Spiegels und/oder zur Bestimmung der Position des Spiegels dienen, insbesondere Aktuatoren und/oder Sensoren und/oder zugehörige Signalleitungen gegen freie Ladungen abgeschirmt sind.

Bei der Spiegel-Einrichtung handelt es sich insbesondere um ein optisches Bauelement zum Einsatz in einer Projektionsbelichtungsanlage, insbesondere in einer EUV-Projektionsbelichtungsanlage. Die Spiegel-Einrichtung wird insbesondere in einer verdünnten Gasumgebung, insbesondere in einer Vakuumumgebung oder einer Wasserstoff-Umgebung mit einem reduzierten Druck von höchstens 50 Pa, insbesondere einem $H_2$-Partialdruck, eingesetzt.

Die Vorderseite des Spiegel-Körpers umfasst insbesondere eine Reflexionsfläche. Sie kann insbesondere die Reflexionsfläche bilden. Die Reflexionsfläche kann sich insbesondere über die gesamte Vorderseite des Spiegel-Körpers erstrecken.

Der Spiegel ist insbesondere als ein Spiegel für EUV-Strahlung ausgebildet. Er ist insbesondere zur Reflexion von Strahlung im EUV-Bereich, insbesondere zur Strahlung mit einer Wellenlänge im Bereich von 5 nm bis 30 nm, insbesondere einer Wellenlänge von 13,5 nm ausgelegt. Die Reflexionsfläche kann durch eine Viellagenschicht gebildet sein. Beim Spiegel kann es sich auch um einen Spiegel für DUV- oder VUV-Strahlung handeln.

Die Spiegel-Einrichtung ist insbesondere zum Einsatz in einer evakuierbaren Kammer geeignet. Sie kann insbesondere in einer evakuierbaren Kammer einer Projektionsbelichtungsanlage angeordnet sein, welche beim Betrieb der Projektionsbelichtungsanlage auf einen Druck von weniger als 50 Pa, insbesondere weniger als 20 Pa, insbesondere weniger als 10 Pa, insbesondere weniger als 5 Pa evakuiert wird. Hierbei gibt dieser Druck insbesondere den Partialdruck von Wasserstoff in der Kammer an.

Die Spiegel-Einrichtung ist insbesondere zum Einsatz in einer teilweise oder vollständig ionisierten Umgebung, insbesondere in einer Plasmaumgebung, geeignet.

Weiter wurde erkannt, dass es aufgrund der Beleuchtungsstrahlung zu einer Ionisierung oder Plasmabildung in der Umgebung der Spiegel-Einrichtung kommen kann. Ohne geeignete Schutzmaßnahmen kann dies dazu führen, dass geladene Teilchen auf die Rückseite der Spiegel, insbesondere in ein Volumen hinter den Spiegeln, insbesondere zu Aktuatoren für die Verlagerung der Spiegel und/oder Sensoren und/oder deren Anschlussleitungen gelangen und somit zu Störungen der Positionierung der Spiegel führen. Erfindungsgemäß ist vorgesehen, dies durch Erzeugung eines elektrischen Feldes in einem an die mindestens eine Seitenfläche und/oder die Rückseite des Spiegels angrenzenden Bereichs zu verhindern. Durch ein geeignetes elektrisches Feld kann insbesondere verhindert werden, dass durch die Beleuchtungsstrahlung ionisierte Teilchen in ein zu schützendes Volumen hinter dem Spiegel gelangen.

Gemäß einem Aspekt der Erfindung weist das elektrische Feld eine Feldstärke von zu $10^7$ V/m, insbesondere bis zu $10^8$ V/m auf. Die Feldstärke beträgt insbesondere mindestens $10^5$ V/m, insbesondere höchstens $10^6$ V/m.

Durch das elektrische Feld kann insbesondere das Volumen im Bereich direkt hinter dem Spiegel-Körper, insbesondere das Volumen, welches bei einer Parallelprojektion in Richtung parallel zu einer Normalen der Reflexionsfläche des Spiegels im unverschwenkten Zustand, begrenzt wird, abgeschirmt werden. Dieses Volumen wird auch als Schattenwurfvolumen bezeichnet.

In dem abgeschirmten Volumen können sensitive Bauelemente, insbesondere sensitive elektronische Bauelemente, und/oder Leiterbahnen, und/oder Materialien, die empfindlich auf ionisierte Teilchen reagieren, angeordnet werden.

Gemäß einem Aspekt der Erfindung wird das elektrische Feld in einem an die Seitenfläche des Spiegels angrenzenden Bereich, welcher sich insbesondere senkrecht zur vorgenannten Normalen auf der Reflexionsfläche des Spiegels erstreckt, erzeugt. Das elektrische Feld kann insbesondere im Bereich zwischen zwei benachbarten Spiegeln, das heißt im Bereich des Zwischenraums zwischen zwei benachbarten Spiegeln, erzeugt werden. Hierdurch kann verhindert werden, dass geladene Teilchen durch diesen Zwischenraum aus dem Volumen vor der Vorderseite des Spiegels auf die Rückseite des Spiegels gelangen können.

Gemäß einem Aspekt der Erfindung ist das Abschirm-Element als Leiterbahn, Draht, elektrisch leitfähiger Streifen oder Schicht aus dotiertem Silizium ausgebildet oder umfasst eine derartige Struktur. Das Abschirm-Element kann insbesondere die gesamte Fläche der Seitenwand eines Spiegels abdecken. Es kann auch lediglich einen schmaleren Streifen derselben abdecken. Der Streifen verläuft insbesondere parallel zur Reflexionsfläche des Spiegels, insbesondere zur vorderen Berandung der Seitenfläche des Spiegels. Allgemein wurde gefunden, dass je breiter dieser Streifen ausgebildet ist, desto niedriger kann die Abschirm-Spannung, mit welcher das Abschirm-Element beaufschlagt wird, gewählt werden. Die Abschirm-Elemente können insbesondere über elektrische Zuleitungen im Spiegel-körper mit Spannung beaufschlagt werden.

Das Abschirm-Element kann auch aus einer Mehrzahl von Drähten, insbesondere einem Gitter, bestehen oder ein derartiges Gitter umfassen. Es kann auch spulenartig ausgebildet sein oder jeweils eine oder mehrere Spulen oder spulenartige Strukturen umfassen. In diesem Fall kann zur Abschirmung freier Ladungsträger auch ein durch die Spulen oder spulenartigen Strukturen erzeugbares Magnetfeld dienen. In diesem Fall ist die Stromstärke in der Leiterbahn der entscheidende Parameter für die abschirmende Wirkung.

Gemäß einem weiteren Aspekt der Erfindung ist mindestens eines der elektrisch leitfähigen Abschirm-Elemente im Bereich der mindestens einen Seitenfläche und/oder im Bereich auf oder hinter der Rückseite des Spiegels angeordnet. Das Abschirm-Element kann insbesondere bei einer nach vorne weisenden Reflexionsfläche des Spiegels hinter der Rückseite des Spiegels angeordnet sein.

Es hat sich ergeben, dass hierdurch das Volumen im Bereich hinter dem Spiegelkörper wirksam abschirmbar ist.

Das elektrisch leitfähige Abschirm-Element kann direkt am oder im Spiegel-Körper angeordnet sein. Es kann auch auf einem Substrat, welches zur mechanischen Halterung des Spiegel-Körpers dient, angeordnet sein.

Gemäß einem weiteren Aspekt der Erfindung umfasst die Spiegel-Einrichtung eine Spannungsquelle zur Beaufschlagung mindestens eines der elektrisch leitfähigen Abschirm-Elemente mit elektrischer Spannung, insbesondere im Bereich von -300 V bis 300 V. Der Betrag der von der Spannungsquelle zur Verfügung gestellten elektrischen Spannung beträgt insbesondere mindestens 10 V, insbesondere mindestens 20 V, insbesondere mindestens 30 V, insbesondere mindestens 50 V, insbesondere mindestens 70 V. Er beträgt insbesondere höchstens 300 V, insbesondere höchstens 200 V. Er kann insbesondere höchstens 100 V betragen.

Erfindungsgemäß wurde erkannt, dass der zur Abschirmung der freien Ladungsträger erforderliche Wert der Abschirmspannung von der Geometrie der Spiegel-Körper, insbesondere von deren Erstreckung in Richtung senkrecht zur Reflexionsfläche, sowie dem Abstand benachbarter Spiegel-Körper abhängt. Weiterhin hängt er von Energie der Photonen der Beleuchtungsstrahlung sowie der Ionisierungsenergie der Gaspartikel im Bereich des Spiegel-Elements ab. Es konnte gezeigt werden, dass mit dem vorhergehend genannten Werten der Abschirmspannung eine wirksame Abschirmung der sensitiven Bauelemente erreicht werden kann.

Gemäß einem weiteren Aspekt der Erfindung ist das Abschirm-Element mit einer Gleichspannung, insbesondere einer im Wesentlichen konstanten Gleichspannung, beaufschlagt. Die zur Beaufschlagung des Abschirm-Elements verwendete Spannung wird auch als Abschirm-Spannung bezeichnet. Gemäß einem Aspekt der Erfindung ist die Abschirm-Spannung mindestens so groß wie die Spannung in den Signalleitungen, welche zur Steuerung der Positionierung des Spiegels vorgesehen sind. Sie ist insbesondere um mindestens einen Faktor 2, insbesondere mindestens einen Faktor 3, insbesondere mindestens einen Faktor 5, insbesondere mindestens einen Faktor 10 größer als die Spannung in den Signalleitungen, welche zur Steuerung der Positionierung des Spiegels vorgesehen sind. Die Signalleitungen werden insbesondere mit einer elektrischen Spannung von maximal 100 V, insbesondere maximal 24 V, insbesondere maximal 12 V, insbesondere maximal 6 V, insbesondere maximal 3,3 V beaufschlagt.

Der exakte Wert der Abschirmspannung kann in Abhängigkeit von der geometrischen Anordnung des Abschirm-Elements und des abzuschirmenden Bereichs gewählt werden.

Gemäß einem weiteren Aspekt der Erfindung umfasst die Spiegel-Einrichtung eine Steuer-Einrichtung zur Regelung der elektrischen Spannung auf einen Sollwert, mit welcher mindestens eines der elektrisch leitfähigen Abschirm-Elemente beaufschlagt wird. Dies ermöglicht es, die Abschirm-Spannung flexibel an die jeweiligen Erfordernisse anzupassen. Die Abschirmung wird in diesem Fall auch als aktive Abschirmung (active shielding) bezeichnet. Hierunter sei insbesondere verstanden, dass die Abschirmleitung mit einer geregelten Spannung beaufschlagt wird.

Gemäß einem weiteren Aspekt der Erfindung sind die Abschirm-Elemente jeweils paarweise angeordnet. Dies erleichtert es, das elektrische Feld, welches zur Abschirmung der freien Ladungen dient, präzise zu steuern.

Es kann insbesondere vorgesehen sein, in einem oder mehreren der Spiegel-Körper, insbesondere in sämtlichen der Spiegel-Körper, jeweils mehrere, insbesondere jeweils zwei, insbesondere jeweils vier Abschirm-Elemente anzuordnen.

Gemäß einem Aspekt der Erfindung sind die Abschirm-Elemente jeweils in oder an unterschiedlichen Seitenflächen der Spiegel-Körper angeordnet. Gemäß einem Aspekt der Erfindung ist insbesondere in oder an jeder der Seitenflächen des Spiegelkörpers ein Abschirm-Element angeordnet. Dies ermöglicht es insbesondere, in sämtlichen Bereichen zwischen benachbarten Spiegeln jeweils ein elektrisches Feld zur Abschirmung der freien Ladungen zu erzeugen.

Gemäß einem weiteren Aspekt der Erfindung umfasst die Spiegel-Einrichtung eine Mehrzahl von Spiegeln. Die Spiegel sind insbesondere in einem Array, insbesondere in Zeilen und Spalten, das heißt matrixartig, angeordnet. Die Erfindung betrifft insbesondere ein derartiges Spiegel-Array, welches auch als Vielspiegel-Anordnung bezeichnet wird. Die Anzahl der Spiegel der Spiegel-Einrichtung beträgt insbesondere mindestens 100, insbesondere mindestens 1000, insbesondere mindestens 10000, insbesondere mindestens 100000. Die Anzahl beträgt üblicherweise weniger als 1000000.

Die Spiegel-Einrichtung ist insbesondere als mikroelektromechanisches System (MEMS), insbesondere als mikrooptoelektromechanisches Systems (MOEMS) ausgebildet. Sie kann insbesondere als Facettenspiegel, insbesondere als Feldfacettenspiegel einer Beleuchtungsoptik für eine Projektionsbelichtungsanlage dienen, beziehungsweise einen derartigen Facettenspiegel bilden.

Benachbarte Spiegel der Spiegel-Einrichtung sind jeweils durch kleine Zwischenräume beabstandet zueinander angeordnet. Hierbei ist vorgesehen, die Zwischenräume so klein, insbesondere so schmal wie möglich, zu halten. Die relative Größe der Zwischenräume kann durch den Füllfaktor der Spiegel-Einrichtung charakterisiert werden. Dieser Wert wird auch als Integrationsdichte bezeichnet. Die Integrationsdichte bezeichnet insbesondere das Verhältnis der Summe der Reflexionsflächen der einzelnen Spiegel zur Gesamtfläche der Spiegel-Einrichtung, das heißt der Summe der Reflexionsflächen der Spiegel oder der Zwischenräume zwischen denselben. Der Füllfaktor beziehungsweise die Integrationsdichte der Spiegel-Einrichtung beträgt mindestens 0,5, insbesondere mindestens 0,6, insbesondere mindestens 0,7, insbesondere mindestens 0,8, vorzugsweise mindestens 0,9, vorzugsweise mindestens 0,96.

Gemäß einem weiteren Aspekt der Erfindung ist jedem Zwischenraum zwischen zwei benachbarten Spiegeln jeweils ein Abschirm-Element oder ein Paar von Abschirm-Elementen zugeordnet. Es ist auch möglich, den Zwischenräumen mehr als zwei Abschirm-Elemente zuzuordnen.

Gemäß einem Aspekt der Erfindung ist jeweils mindestens ein Abschirm-Element im Bereich hinter einem Zwischenraum zwischen zwei benachbarten Spiegeln angeordnet. Das Abschirm-Element ist in diesem Fall vorzugsweise auf dem Substrat, welches zur Halterung der Spiegel-Körper und/oder zur Anordnung der Steuerelektronik zur Verlagerung der Spiegel dient, angeordnet.

Der Bereich hinter einem Zwischenraum bezeichnet hierbei insbesondere den Volumenbereich auf der Rückseite des Spiegel-Körpers, in welchem freie Ladungen aus dem Volumenbereich vor der Vorderseite des Spiegel-körpers bei einer geradlinigen Trajektorie prinzipiell gelangen können. Es kann sich insbesondere um den Bereich handeln, welcher durch eine Projektion des Bereichs des Zwischenraums zwischen zwei benachbarten Spiegeln auf das Substrat definiert ist. Bei der Projektion kann es sich um eine Senkrechtprojektion auf das Substrat handeln. Es kann sich auch um eine Schrägprojektion auf das Substrat handeln.

Gemäß einem weiteren Aspekt der Erfindung sind jeweils zwei Abschirm-Elemente paarweise im Bereich einander gegenüberliegender Seitenflächen benachbarter Spiegel angeordnet. Sie dienen insbesondere zum Aufbau eines elektrischen Feldes im Bereich des Zwischenraums zwischen den benachbarten Spiegeln.

Durch Abschirm-Elemente im Bereich hinter dem Zwischenraum und/oder durch paarweise Anordnung von Abschirm-Elementen auf einander gegenüberliegenden Seiten des Zwischenraums lässt sich besonders wirksam verhindern, dass Ladungen, insbesondere energiereiche Ladungsträger, aus dem Bereich vor der Vorderseite der Spiegel in den Bereich hinter der Rückseite der Spiegel, insbesondere in den Bereich mit sensitiven elektrischen Bauelementen, gelangen. Hierdurch kann die Positionierung der einzelnen Spiegel verbessert werden. Es ist insbesondere möglich, die Stabilität der Positionierung der einzelnen Spiegel zu verbessern.

Weitere Aufgaben der Erfindung bestehen darin, eine Beleuchtungsoptik und ein Beleuchtungssystem für eine Projektionsbelichtungsanlage sowie eine entsprechende Projektionsbelichtungsanlage zu verbessern. Diese Aufgaben werden durch eine Beleuchtungsoptik mit mindestens einer Spiegel-Einrichtung gemäß der vorhergehenden Beschreibung beziehungsweise ein Beleuchtungssystem und eine Projektionsbelichtungsanlage mit einer derartigen Beleuchtungsoptik gelöst. Die Vorteile ergeben sich aus denen der Spiegel-Einrichtung.

Weitere Aufgaben der Erfindung bestehen darin, ein Verfahren zur Herstellung eines mikro- oder nanostrukturierten Bauelements sowie ein entsprechendes Bauelement zu verbessern. Diese Aufgaben werden durch die Bereitstellung einer erfindungsgemäßen Projektionsbelichtungsanlage gelöst. Die Vorteile ergeben sich ebenfalls aus denen der Spiegel-Einrichtung.

Weitere Einzelheiten und Vorteile der Erfindung ergeben sich aus der Beschreibung von Ausführungsbeispielen anhand der Zeichnungen. Es zeigen:

Fig. 1          eine schematische Darstellung einer Projektionsbelichtungsanlage für die Mikrolithographie,

Fig. 2          eine schematische Darstellung eines Ausschnitts aus einer Schnittdarstellung einer Vielspiegel-Anordnung im Bereich zweier benachbarter Einzelspiegel,

Fig. 3A und 3B  eine Ausschnittsvergrößerung des Bereichs III aus Fig. 2 mit einer exemplarischen Darstellung eines Feldlinienverlaufs eines elektrischen Feldes bei unterschiedlichen Aktivierungszuständen der Aktuatoren zur Verlagerung der Einzelspiegel,

Fig. 4          schematisch einen Ausschnitt aus einer Aufsicht auf eine Vielspiegel-Anordnung zur exemplarischen Verdeutlichung einer paarweisen Anordnung von Abschirm-Elektroden im Bereich der Seitenflächen benachbarter Einzelspiegel,

Fig. 5          schematisch eine Ansicht von oben (linke Spalte), von unten (rechte Spalte) beziehungsweise in einem Vertikalschnitt (mittlere Spalte) einer Abfolge von Zwischenprodukten bei einem Verfahren zur Herstellung der Einzelspiegel,

Fig. 6          eine Darstellung entsprechend der Fig. 5 bei einem Verfahren zur Herstellung eines Haltestifts,

Fig. 7          eine Darstellung entsprechend den Fig. 5 und 6 bei einem Verfahren zur Herstellung eines aus dem Spiegel gemäß Fig. 5 und dem Haltestift gemäß Fig. 6 zusammengesetzten Spiegel-Element,

Fig. 8          eine Darstellung eines Vertikalschnitts durch Zwischenprodukte bei einem Verfahren zur Herstellung einer VielspiegelAnordnung aus dem zusammengesetzten Spiegel gemäß Fig. 7,

Fig. 9 bis 12   Darstellungen gemäß den Fig. 5 bis 8 gemäß einer Alternative,

Fig. 13         eine Darstellung gemäß Fig. 2 einer alternativen Ausführungsform des Abschirm-Elements und

Fig. 14         eine Darstellung eines exemplarischen Verlaufs der Feldlinien eines elektrischen Feldes bei einer Aktivierung des Abschirm-Elements gemäß Fig. 13.

Im Folgenden werden zunächst der allgemeine Aufbau und die wesentlichen Bestandteile einer Projektionsbelichtungsanlage 1 für die Mikrolithographie exemplarisch geschildert. Die Beschreibung der allgemeinen Details ist rein exemplarisch, insbesondere nicht einschränkend zu verstehen.

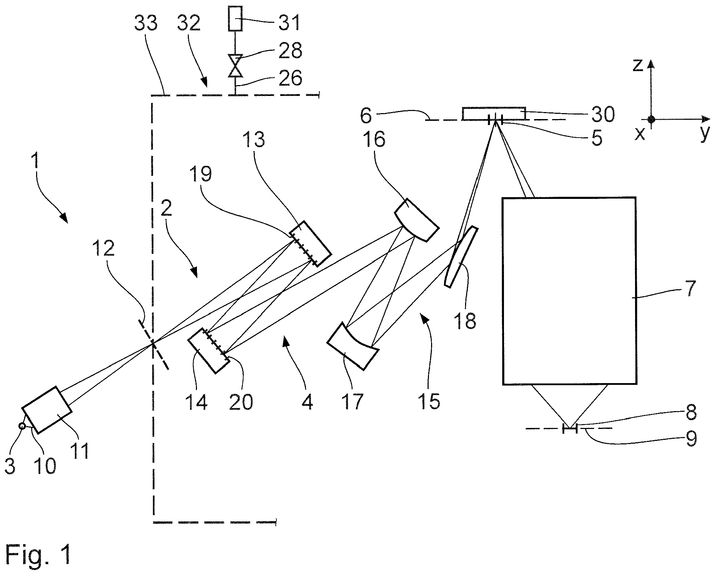

Fig. 1 zeigt schematisch in einem Meridionalschnitt eine Projektionsbelichtungsanlage 1 für die Mikrolithografie. Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6. Das Objektfeld 5 kann rechteckig oder bogenförmig mit einem x/y-Aspektverhältnis von beispielsweise 13/1 gestaltet sein. Belichtet wird hierbei ein im Objektfeld 5 angeordnetes und in der Fig. 1 nicht dargestelltes reflektierendes Retikel 30, das eine mit der Projektionsbelichtungsanlage 1 zur Herstellung mikro- bzw. nanostrukturierter Halbleiter-Bauelemente zu projizierende Struktur trägt. Eine Projektionsoptik 7 dient zur Abbildung des Objektfeldes 5 in ein Bildfeld 8 in einer Bildebene 9. Abgebildet wird die Struktur auf dem Retikel 30 auf eine lichtempfindliche Schicht eines im Bereich des Bildfeldes 8 in der Bildebene 9 angeordneten Wafers, der in der Zeichnung nicht dargestellt ist.

Das Retikel 30, das von einem nicht dargestellten Retikelhalter gehalten ist, und der Wafer, der von einem nicht dargestellten Waferhalter gehalten ist, werden beim Betrieb der Projektionsbelichtungsanlage 1 synchron in der y-Richtung gescannt. Abhängig vom Abbildungsmaßstab der Projektionsoptik 7 kann auch ein gegenläufiges Scannen des Retikels 30 relativ zum Wafer stattfinden.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, Gas Discharge Produced Plasma), oder um eine LPP-Quelle (Plasmaerzeugung durch Laser, Laser Produced Plasma) handeln. Auch andere EUV-Strahlungsquellen, beispielsweise solche, die auf einem Synchrotron oder auf einem Free Electron Laser (Freie Elektronenlaser, FEL) basieren, sind möglich.

Es kann sich auch um eine VUV-Strahlungsquelle, insbesondere zur Erzeugung von Strahlung mit einer Wellenlänge von weniger als 200 nm handeln.

EUV-Strahlung 10, die von der Strahlungsquelle 3 ausgeht, wird von einem Kollektor 11 gebündelt. Ein entsprechender Kollektor ist beispielsweise aus der EP 1 225 481 A bekannt. Nach dem Kollektor 11 propagiert die EUV-Strahlung 10 durch eine Zwischenfokusebene 12, bevor sie auf einen Feldfacettenspiegel 13 trifft. Der Feldfacettenspiegel 13 ist in einer Ebene der Beleuchtungsoptik 4 angeordnet, die zur Objektebene 6 optisch konjugiert ist.

Die EUV-Strahlung 10 wird nachfolgend auch als Nutzstrahlung, Beleuchtungslicht oder als Abbildungslicht bezeichnet. Bei der Nutzstrahlung kann es sich auch um VUV-Strahlung, insbesondere mit einer Wellenlänge von weniger als 200 nm handeln.

Nach dem Feldfacettenspiegel 13 wird die EUV-Strahlung 10 von einem Pupillenfacettenspiegel 14 reflektiert. Der Pupillenfacettenspiegel 14 liegt entweder in der Eintrittspupillenebene der Beleuchtungsoptik 7 oder in einer hierzu optisch konjugierten Ebene. Der Feldfacettenspiegel 13 und der Pupillenfacettenspiegel 14 sind aus einer Vielzahl von Einzelspiegeln aufgebaut, die nachfolgend noch näher beschrieben werden. Dabei kann die Unterteilung des Feldfacettenspiegels 13 in Einzelspiegel derart sein, dass jede der Feldfacetten 19, die für sich das gesamte Objektfeld 5 ausleuchten, durch genau einen der Einzelspiegel repräsentiert wird. Alternativ ist es möglich, zumindest einige oder alle der Feldfacetten 19 durch eine Mehrzahl derartiger Einzelspiegel aufzubauen. Entsprechendes gilt für die Ausgestaltung der den Feldfacetten 19 jeweils zugeordneten Pupillenfacetten 20 des Pupillenfacettenspiegels 14, die jeweils durch einen einzigen Einzelspiegel oder durch eine Mehrzahl derartiger Einzelspiegel gebildet sein können.

Die EUV-Strahlung 10 trifft auf die beiden Facettenspiegel 13, 14 unter einem Einfallswinkel auf, der kleiner oder gleich 25° ist. Die beiden Facettenspiegel werden also im Bereich eines normal incidence-Betriebs mit der EUV-Strahlung 10 beaufschlagt. Auch eine Beaufschlagung unter streifendem Einfall (grazing incidence) ist möglich. Der Pupillenfacettenspiegel 14 ist in einer Ebene der Beleuchtungsoptik 4 angeordnet, die eine Pupillenebene der Projektionsoptik 7 darstellt bzw. zu einer Pupillenebene der Projektionsoptik 7 optisch konjugiert ist. Mithilfe des Pupillenfacettenspiegels 14 und einer abbildenden optischen Baugruppe in Form einer Übertragungsoptik 15 mit in der Reihenfolge des Strahlengangs für die EUV-Strahlung 10 bezeichneten Spiegeln 16, 17 und 18 werden die Feldfacetten 19 des Feldfacettenspiegels 13 einander überlagernd in das Objektfeld 5 abgebildet. Der letzte Spiegel 18 der Übertragungsoptik 15 ist ein Spiegel für streifenden Einfall ("Grazing incidence Spiegel"). Die Übertragungsoptik 15 wird zusammen mit dem Pupillenfacettenspiegel 14 auch als Folgeoptik zur Überführung der EUV-Strahlung 10 vom Feldfacettenspiegel 13 hin zum Objektfeld 5 bezeichnet. Das Beleuchtungslicht 10 wird von der Strahlungsquelle 3 hin zum Objektfeld 5 über eine Mehrzahl von Ausleuchtungskanälen geführt. Jedem dieser Ausleuchtungskanäle ist eine Feldfacette 19 des Feldfacettenspiegels 13 und eine dieser nachgeordnete Pupillenfacette des Pupillenfacettenspiegels 14 zugeordnet. Die Einzelspiegel des Feldfacettenspiegels 13 und des Pupillenfacettenspiegels 14 können aktuatorisch verkippbar sein, sodass ein Wechsel der Zuordnung der Pupillenfacetten 20 zu den Feldfacetten 19 und entsprechend eine geänderte Konfiguration der Ausleuchtungskanäle erreicht werden kann. Es resultieren unterschiedliche Beleuchtungssettings, die sich in der Verteilung der Beleuchtungswinkel des Beleuchtungslichts 10 über das Objektfeld 5 unterscheiden.

Zur Erleichterung der Erläuterung von Lagebeziehungen wird nachfolgend unter anderem ein globales kartesisches xyz-Koordinatensystem verwendet. Die x-Achse verläuft in der Fig. 1 senkrecht zur Zeichenebene auf den Betrachter zu. Die y-Achse verläuft in der Fig. 1 nach rechts. Die z-Achse verläuft in der Fig. 1 nach oben.

Über eine entsprechende Verkippung der Einzelspiegel des Feldfacettenspiegels 13 und einen entsprechenden Wechsel der Zuordnung dieser Einzelspiegel des Feldfacettenspiegels 13 zu den Einzelspiegeln des Pupillenfacettenspiegels 14 können unterschiedliche Beleuchtungssettings erreicht werden. Abhängig von der Verkippung der Einzelspiegel des Feldfacettenspiegels 13 werden die diesen Einzelspiegeln neu zugeordneten Einzelspiegel des Pupillenfacettenspiegels 14 sofern nötig so durch Verkippung nachgeführt, dass wiederum eine Abbildung der Feldfacetten 19 des Feldfacettenspiegels 13 in das Objektfeld 5 gewährleistet ist.

Der Feldfacettenspiegel 13 in Form eines Multi- bzw. Mikrospiegel-Arrays (MMA) bildet eine optische Baugruppe zur Führung der Nutzstrahlung 10, also des EUV-Strahlungsbündels. Der Feldfacettenspiegel 13 ist als mikroelektromechanisches System (MEMS) ausgebildet. Er weist eine Vielzahl von matrixartig zeilen- und spaltenweise in einem Array angeordneten Einzelspiegeln 27 auf. Die Einzelspiegel 27 sind aktuatorisch verkippbar ausgelegt, wie nachfolgend noch erläutert wird. Insgesamt weist der Feldfacettenspiegel 13 etwa 100000 der Einzelspiegel 27 auf. Je nach Größe der Einzelspiegel 27 kann der Feldfacettenspiegel 13 auch beispielsweise 1000, 5000, 7000 oder auch mehrere hunderttausend, insbesondere mindestens 100000, insbesondere mindestens 300000, insbesondere mindestens 500000 Einzelspiegel 27 aufweisen.

Vor dem Feldfacettenspiegel 13, das heißt zwischen der Strahlungsquelle 3 und dem Feldfacettenspiegel 13, kann ein Spektralfilter angeordnet sein, der die Nutzstrahlung 10 von anderen, nicht für die Projektionsbelichtung nutzbaren Wellenlängenkomponenten der Emission der Strahlungsquelle 3 trennt. Der Spektralfilter ist nicht dargestellt.

Der Feldfacettenspiegel 13 wird mit Nutzstrahlung 10 mit einer Leistung von 840 W und einer Leistungsdichte von 6,5 kW/m$^2$ beaufschlagt. Allgemein sind auch andere Leistungen und Leistungsdichten möglich. Die Leistungsdichte beträgt mindestens 500 W/m$^2$, insbesondere mindestens 1 kW/m$^2$, insbesondere mindestens 5 kW/m$^2$, insbesondere mindestens 10 kW/m$^2$, insbesondere mindestens 60 kW/m$^2$.

Das gesamte Einzelspiegel-Array des Facettenspiegels 13 hat einen Durchmesser von 500 mm und ist dicht gepackt mit den Einzelspiegeln 27 ausgelegt. Die Einzelspiegel 27 repräsentieren, soweit eine Feldfacette 19 durch jeweils genau einen Einzelspiegel realisiert ist, bis auf einen Skalierungsfaktor die Form des Objektfeldes 5. Der Facettenspiegel 13 kann aus 500 jeweils eine Feldfacette 19 repräsentierenden Einzelspiegeln 27 mit einer Dimension von etwa 5 mm in der y-Richtung und 100 mm in der x-Richtung gebildet sein. Alternativ zur Realisierung jeder Feldfacette 19 durch genau einen Einzelspiegel 27 kann jede der Feldfacetten 19 durch Gruppen von kleineren Einzelspiegeln 27 approximiert werden. Eine Feldfacette 19 mit Dimensionen von 5 mm in der y-Richtung und von 100 mm in der x-Richtung kann z. B. mittels eines 1 x 20-Arrays von Einzelspiegeln 27 der Dimension 5 mm x 5 mm bis hin zu einem 10 x 200-Array von Einzelspiegeln 27 mit den Dimensionen 0,5 mm x 0,5 mm aufgebaut sein. Komplexere Aufteilungen der Spiegelflächen sind möglich. Die Einzelspiegel 27 können insbesondere individuell verkippt werden. Die Flächenabdeckung des kompletten Feldfacetten-Arrays durch die Einzelspiegel 27 kann mindestens 70 %, insbesondere mindestens 80 %, insbesondere mindestens 90 % betragen.

Von den Einzelspiegeln 27 des Facettenspiegels 13 wird das Nutzlicht 10 hin zu dem Pupillenfacettenspiegel 14 reflektiert. Der Pupillenfacettenspiegel 14 hat etwa 2000 statische Pupillenfacetten 20. Diese sind in einer Mehrzahl konzentrischer Ringe nebeneinander angeordnet, sodass die Pupillenfacette 20 des innersten Rings sektorförmig und die Pupillenfacetten 20 der sich hieran unmittelbar anschließenden Ringe ringsektorförmig gestaltet sind. In einem Quadranten des Pupillenfacettenspiegels 14 können in jedem der Ringe 12 Pupillenfacetten 20 nebeneinander vorliegen. Die Pupillenfacetten 20 können jeweils einfach zusammenhängend ausgebildet sein. Eine hiervon abweichende Anordnung der Pupillenfacetten 20 ist ebenfalls möglich. Sie können auch aus einer Vielzahl von Einzelspiegeln 27 gebildet sein. Der Pupillenfacettenspiegel 14 kann insbesondere auch als Vielspiegelanordnung (Multi Mirror Array, MMA) mit einer Vielzahl an Einzelspiegeln 27 ausgebildet sein. Er kann insbesondere als MEMS ausgebildet sein. Er bildet allgemein einen zweiten facettierten Spiegel. Von den Pupillenfacetten 20 wird das Nutzlicht 10 hin zu einem reflektierenden Retikel 30 reflektiert, das in der Objektebene 6 angeordnet ist. Es schließt sich dann die Projektionsoptik 7 an, wie vorstehend erläutert.

Die Einzelspiegel 27 des Feldfacettenspiegels 13 und des Pupillenfacettenspiegels 14 tragen Multilayer-Beschichtungen zur Optimierung ihrer Reflektivität bei der Wellenlänge der Nutzstrahlung 10. Die Temperatur der Multilayer-Beschichtungen sollte 425 K beim Betreiben der Projektionsbelichtungs-anlage 1 nicht überschreiten.

Für Details des Aufbaus der Einzelspiegel 27 und deren Verlagerbarkeit sei auf die WO 2010/049 076 A1 verwiesen. Die Beleuchtungsoptik 4 ist in einer evakuierbaren Kammer 32 untergebracht, von der in der Fig. 1 eine Begrenzungswand 33 angedeutet ist. Die Kammer 32 kommuniziert über eine Fluidleitung 26, in der ein Absperrventil 28 untergebracht ist, mit einer Vakuumpumpe 31.

Der Betriebsdruck in der evakuierbaren Kammer 32 beträgt einige Pa (Partialdruck H$_2$). Der Partialdruck von Wasserstoff beträgt insbesondere höchstens 50 Pa, insbesondere höchstens 20 Pa, insbesondere höchstens 10 Pa, insbesondere höchstens 5 Pa. Alle anderen Partialdrücke liegen deutlich unterhalb von $1 \times 10^{-7}$ mbar. Die Kammer 32 kann insbesondere auf Hochvakuum oder Ultrahochvakuum evakuiert werden.

Der die Mehrzahl von Einzelspiegeln 27 aufweisende Spiegel ist zusammen mit der evakuierbaren Kammer 32 Bestandteil eines optischen Bauelements zur Führung eines Bündels der EUV-Strahlung 10. Der Einzelspiegel 27 kann Teil eines der Facettenspiegel 13, 14 sein.

Jeder der Einzelspiegel 27 kann eine beaufschlagbare Reflexionsfläche 34 mit Abmessungen von 0,5 mm x 0,5 mm oder auch von 5 mm x 5 mm und größer aufweisen. Die Reflexionsfläche 34 ist Teil eines Spiegelkörpers 35 des Einzelspiegels 27. Der Spiegelkörper 35 trägt die Mehrlagen-(Multilayer)-Beschichtung. Die Einzelspiegel 27 bzw. deren Reflexionsfläche 34 können auch andere Abmessungen aufweisen. Sie sind insbesondere als Kacheln ausgebildet, mit welchen sich eine zweidimensionale Fläche parkettieren lässt. Sie sind insbesondere dreieckig, viereckig, insbesondere quadratisch, oder hexagonal ausgebildet. Ihre Seitenlängen haben insbesondere Abmessungen von höchstens 10 mm, insbesondere höchstens 5 mm, insbesondere höchstens 3 mm, insbesondere höchstens 1 mm, insbesondere höchstens 0,5 mm, insbesondere höchstens 0,3 mm, insbesondere höchstens 0,1 mm. Es kann sich somit insbesondere um Mikrospiegel handein. Hierunter seien insbesondere Spiegel mit Abmessungen im Mikrometerbereich verstanden.

Die Einzelspiegel 27 sind jeweils mittels einer Aktuator-Einrichtung mit mehreren elektromagnetisch, insbesondere elektrostatisch arbeitenden Aktuatoren verlagerbar, das heißt positionierbar. Die Aktuatoren lassen sich in einem Batch-Prozess als mikroelektromechanisches System (micro-electromechanical-system, MEMS) herstellen. Für Details sei wiederum auf die WO 2010/049 076 A1 verwiesen.

Eine Summe der Reflexionsflächen 34 auf den Spiegelkörpern 35 ist größer als das 0,5-fache einer von der Gesamt-Reflexionsfläche des Feldfacettenspiegels 13 belegten Gesamtfläche. Die Gesamtfläche ist dabei definiert als die Summe der Reflexionsflächen 34 zuzüglich der Flächenbelegung durch die Zwischenräume zwischen den Reflexionsflächen 34. Ein Verhältnis der Summe der Reflexionsflächen der Spiegelkörper einerseits zu dieser Gesamtfläche wird auch als Integrationsdichte bezeichnet. Diese Integrationsdichte kann auch größer sein als 0,6, insbesondere größer als 0,7, insbesondere größer als 0,8, insbesondere größer als 0,9.

Mit Hilfe der Projektionsbelichtungsanlage 1 wird wenigstens ein Teil des Retikels 30 auf einen Bereich einer lichtempfindlichen Schicht auf dem Wafer zur lithografischen Herstellung eines mikro- bzw. nanostrukturierten Bauelements, insbesondere eines Halbleiterbauelements, z.B. eines Mikrochips abgebildet. Je nach Ausführung der Projektionsbelichtungsanlage 1 als Scanner oder als Stepper werden das Retikel 30 und der Wafer zeitlich synchronisiert in der y-Richtung kontinuierlich im Scannerbetrieb oder schrittweise im Stepperbetrieb verfahren.

Die Beleuchtungsoptik 4 wird vorzugsweise im Hochvakuum oder Ultrahochvakuum betrieben. Hierbei kann sich im Bereich vor den Einzelspiegeln 27, insbesondere vor den Spiegelkörpern 35 mit den Reflexionsflächen 34, ein Plasma 45, insbesondere ein Wasserstoffplasma, bilden. Das Plasma 45 kann insbesondere von energiereichen Photonen der Nutzstrahlung 10 erzeugt werden. Die Eigenschaften des Plasmas 45 sind somit insbesondere von den Eigenschaften der Strahlungsquelle 3, insbesondere deren Betriebsmodus, insbesondere deren Pulsfrequenz und/oder Pulsdauer und/oder Intensität, sowie der Atmosphäre in der Kammer 32 abhängig.

Im Folgenden werden weitere Details des als Vielspiegelanordnung 29 (MMA, Multi Mirror Array) ausgebildeten Facettenspiegels 13 beschrieben. Allgemein bildet die Vielspiegelanordnung 29 eine Spiegel-Einrichtung einer Vielzahl von Einzelspiegeln 27. Die Einzelspiegel 27 sind auf einer Tragestruktur 36 angeordnet. Für Details sei insbesondere auf die WO 2010/049976 A1 verwiesen.

Allgemein umfasst die Spiegel-Einrichtung mindestens einen der Spiegel 27. Die Anzahl der Einzelspiegel 27 der Vielspiegelanordnung (MMA) 29 liegt im Bereich von 1 bis 1000000. Sie kann prinzipiell auch darüber liegen. Sie ist prinzipiell je nach Anforderung frei wählbar.

Die Einzelspiegel 27 können um mindestens 80 mrad, insbesondere mindestens 100 mrad, insbesondere mindestens 120 mrad in jede radiale Richtung verschwenkt werden. Sie weisen insbesondere mindestens zwei Verlagerungs-Freiheitsgrade, insbesondere mindestens zwei Schwenk-Freiheitsgrade, auf.

Die als Mikrospiegel ausgebildeten Einzelspiegel 27 sind an mikroskopischen Biegestrukturen aufgehängt. Letztere können aus einen dünnen Siliziumwafer oder aus einer metallischen Membran oder ähnlichem ausgeschnitten oder ausgeätzt sein. Die Biegestrukturen können insbesondere zweidimensional, das heißt membranartig, oder balkenförmig oder kardanisch ausgebildet sein.

Die Einzelspiegel 27 sind aktuatorisch verlagerbar. Die Aktuierung ist vorzugsweise elektrostatisch oder elektromechanisch oder piezoelektrisch. Alternativen hierzu sind ebenso möglich.

Die Vielspiegelanordnung (MMA) 29 wird durch Mikrostrukturierung, insbesondere durch eine Abfolge mikroelektromechanischer Strukturierungsschritte, insbesondere unter Verwendung von Verfahrensschritte wie beispielsweise lithographische Schritte, Abscheiden, Bonden oder Formen hergestellt. Sie wird insbesondere aus einer Anzahl individueller Wafer hergestellt, welche nach der Bearbeitung miteinander gebondet werden. Details werden nachfolgend noch näher beschrieben.

Die elektrischen Verbindungen, insbesondere die Schaltkreise, können wie folgt hergestellt werden: Die horizontal verlaufenden, das heißt die in Richtung parallel zu einer Waferoberfläche verlaufenden, können als dünne metallische oder dotierte Halbleiter-Schichten auf die Oberfläche der einzelnen Wafer aufgebracht werden. Hierzu kann ein Druck- oder ein Dampfabscheidungsverfahren vorgesehen sein. Die vertikalen elektrischen Verbindungen, das heißt die Verbindungen, welche durch die Wafer, beispielsweise die Tragestruktur 36 hindurchreichen, können beispielsweise als sogenannte Silizium-Durchkontaktierungen, hergestellt werden. Auch hierzu kann ein Verfahren mit mikroelektromechanischen Strukturierungsschritten (MEMS-Verfahren) vorgesehen sein. Die Stukturierungsschritte können insbesondere Ätzschritte zur Herstellung von Vertiefungen, insbesondere Gräben, in einem Substrat, und nachfolgendes Auffüllen derselben, insbesondere mit einem elektrisch leitfähigen Material, wie beispielsweise einem Metall oder einem dotierten Halbleitermaterial, oder Auffüllen mit einem elektrisch isolierenden Material, umfassen.

Die Reflexionsfläche 34 ist auf einer nach vorne weisenden Vorderseite des Spiegelkörpers 35 angeordnet. Sie bildet insbesondere die Vorderseite. Die der Reflexionsfläche 34 der Einzelspiegel 27 entgegengesetzte Seite der Spiegel 35 wird als Rückseite 21 des Spiegelkörpers 27 bezeichnet. Die vom Folgenden verwendeten Richtungsangaben "vorne" und "hinten" beziehen sich auf die Ausrichtung der Vorder- und Rückseite der Spiegelkörper 35. Sie dienen insbesondere der einfacheren Beschreibung von Lagebeziehungen.

Die Reflexionsfläche 34 ist quadratisch ausgebildet. Sie ist allgemein vorzugsweise viereckig, insbesondere parallelogrammförmig, insbesondere rechteckig oder hexagonal ausgebildet. Sie kann prinzipiell auch eine alternative geometrische Ausbildung aufweisen. Sie ist insbesondere derart ausgebildet, dass die Gesamtreflexionsfläche der Spiegel-Einrichtung im Wesentlichen lückenlos durch die Einzelspiegel 27 parkettierbar ist.

Die Spiegelkörper 35 weisen jeweils vier Seitenflächen 22 auf. Die Seitenflächen 22 verlaufen jeweils zwischen der Vorderseite des Spiegelkörpers 35 und der Rückseite 21 desselben. Sie verlaufen insbesondere senkrecht zur Vorder- und Rückseite 21 des Spiegelkörpers 35. Sie können auch schräg zu diesen Seiten verlaufen. In diesem Fall ist der Spiegelkörper 35 pyramidenstumpfförmig ausgebildet.

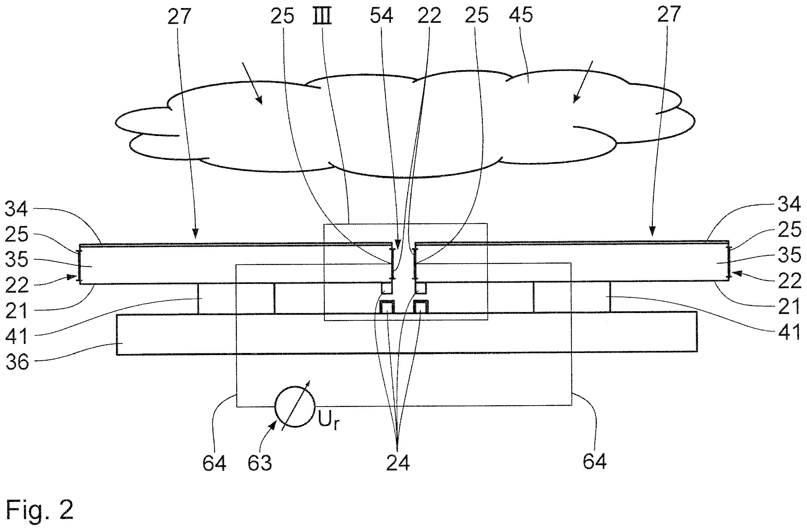

Bei der in Fig. 2 dargestellten Ausführungsform ist zwischen dem Spiegel-körper 35 und der Tragestruktur 36 ein Abstandshalter 41 angeordnet. Der Abstandshalter 41 dient auch als Spiegelaufhängung. Die Spiegelaufhängung fixiert den Drehpunkt des Spiegels im festen Abstand zur Baseplate.

Allgemein ist die Vielspiegel-Anordnung 29 als mikroelektromechanisches System (MEMS) ausgebildet. Die Einzelspiegel 27 sind flexibel, insbesondere verschwenkbar, gelagert. Im Bereich hinter der Rückseite 21 der Einzelspiegel 27 sind elektronische Schaltkreise, insbesondere Aktuator- und/oder Sensorschaltkreise, insbesondere zur Steuerung der Verlagerung der Einzelspiegel 27 vorgesehen. Die Schaltkreise sind insbesondere als anwendungsspezifische integrierte Schaltkreise (ASICs, Application Specific Integrated Circuits) ausgebildet. Die ASICs sind auf die Rückseite der Tragstruktur gebondet. Die elektrischen Leitungen zwischen Aktuator bzw. Sensor und den ASICs verlaufen durch die Tragstruktur 36. Die ASICs können insbesondere in einem gekapselten, insbesondere dicht, insbesondere vakuumdicht nach außen abgeschlossenen Bereich angeordnet sein. Sie sind insbesondere derart ausgebildet und/oder angeordnet, dass sie in einer Vakuumumgebung verwendet werden können.

Im Folgenden werden weitere Details der Vielspiegelanordnung beschrieben, welche insbesondere dazu dienen, die Elektronik, insbesondere die elektronischen Bauteile hinter den Spiegeln, insbesondere die Schaltkreise und/oder die Aktuatorik und/oder Sensorik, sowie ggf. die ASICs, vor geladenen Teilchen, welche insbesondere durch die Beleuchtungsstrahlung erzeugt werden können, zu schützen. Es sind insbesondere Mittel vorgesehen, welche verhindern, dass das von der Beleuchtungsstrahlung 10 erzeugte Plasma 45 zwischen den Einzelspiegeln 27 hindurch dringt und die Elektronik, welche hinter der Rückseite 21 der Spiegelkörper 35 angeordnet ist, insbesondere die Sensoren und/oder Aktuatoren und/oder deren Signalleitungen beeinflusst.

Die Wirksamkeit der erfindungsgemäß vorgesehenen Maßnahmen wurde insbesondere analytisch und im Wege von Simulationen verifiziert.

Allgemein wurde erkannt, dass ein Eindringen von geladenen Teilchen aus dem Volumenbereich vor der Vorderseite der Spiegelkörper 35 in den Bereich hinter der Rückseite 21 derselben durch Erzeugen eines elektrischen Feldes 23 im Bereich zwischen den Seitenflächen 22 der Spiegelkörper 35 verhindert werden kann.

Erfindungsgemäß wurde erkannt, dass sich die Trajektorie eines geladenen Teilchens in einem elektrischen Feld aus seiner kinetischen Energie, seinem Impuls sowie der Verteilung der elektrischen Feldstärke bestimmen lässt. Weiter wurde erkannt, dass es möglich ist, durch geeignete Anpassung der elektrischen Feldstärke des Feldes 23 zu verhindern, dass geladene Teilchen mit einer bekannten maximalen kinetischen Energie vom Bereich vor der Vorderseite der Spiegelkörper 35 in den Bereich hinter der Rückseite 21 der Spiegelkörper 35 gelangen.

Abhängig von einer Dicke d der Spiegelkörper 35, insbesondere einer entsprechenden Erstreckung von Abschirm-Elektroden 25, sowie einem Abstand g benachbarter Spiegelkörper 35, einer bekannten Energie $E_{ph}$ der Photonen der Beleuchtungsstrahlung 10 ($E_{ph}$ = 91,8 eV für EUV) sowie einer Ionisierungsenergie $E_{ion}$ der Gaspartikel in der Kammer 32 ($E_{ion}$ = 15,4 eV für $H_2$) lässt sich bestimmen, wie groß eine Spannung $U_r$ sein muss, um die ionisierten Teilchen wirksam abzubremsen. Es ergab sich, dass eine Spannung $U_r$ in der Größenordnung von 50 V bis 100 V ausreichend ist, um zu verhindern, dass geladene Teilchen aus dem Plasma 45 in den Bereich hinter der Rückseite 21 der Spiegelkörper 35 gelangen können.

Für die Spannung $U_r$, welche nötig ist, um ein Eindringen von geladenen Teilchen aus dem Plasma in den Bereich hinter der Rückseite 21 der Spiegelkörper 35 zu verhindern, ergaben sich insbesondere folgende Abschätzungen:

$$U_r = 2\frac{g}{d}\frac{\left(E_{ph} - E_{ion}\right)}{e}, \text{ für d} \leq 4\text{g}$$

$$U_r = \left(\frac{16g^2}{d^2 + 16g^2}\right)\frac{\left(E_{ph} - E_{ion}\right)}{e} < \frac{1}{2}\frac{\left(E_{ph} - E_{ion}\right)}{e}, \text{ für d} > 4\text{g,}$$

wobei e die Elementarladung bezeichnet.

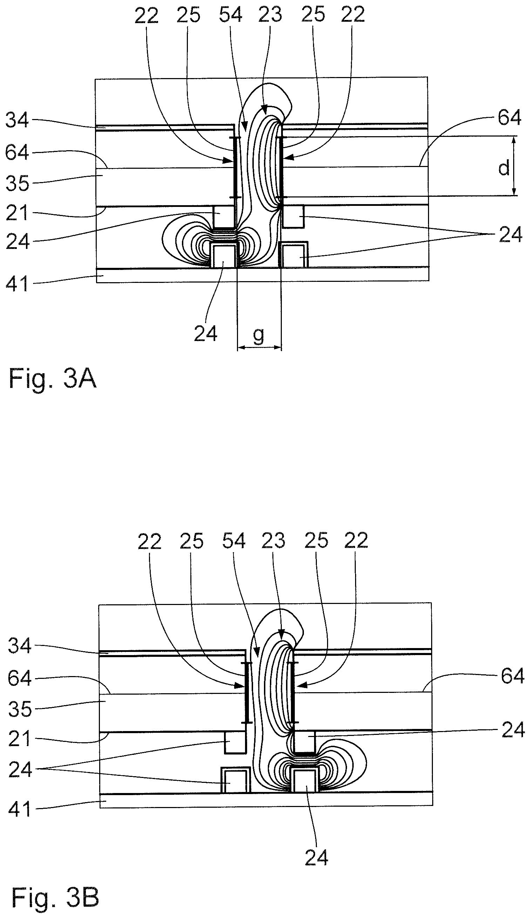

Diese Abschätzungen beruhen auf der Annahme, dass das elektrische Feld 23 im Bereich von Zwischenräumen 54 zwischen den Seitenflächen 22 der Spiegelkörper 35 weitestgehend uniform ist. Dass dies in ausreichender Näherung zutreffend ist, konnte durch realistische Simulationen gezeigt werden. Exemplarische Verteilungen der Feldlinien sind in den Fig. 3A und 3B dargestellt. Hierbei wurde davon ausgegangen, dass zur Verlagerung der Einzelspiegel 27 jeweils ein Paar von Kammelektroden 24 dient. Die Kammelektroden 24 weisen jeweils Abmessungen von 20 $\mu$m · 20 $\mu$m auf. Sie sind jeweils auf der Rückseite 21 der Spiegelkörper 35 angeordnet. Sie sind insbesondere im Bereich der Seitenfläche 22 des Spiegelkörpers 35 angeordnet. Für die Simulation wurde davon ausgegangen, dass sie mit einer maximalen Spannung von 200 V beaufschlagt werden.

Für die Simulation wurde weiter davon ausgegangen, dass die Spiegelkörper 35 in Richtung parallel zu ihrer Vorder- bzw. Rückseite 21 Abmessungen von 600 $\mu$m aufweisen, eine Dicke d von 70 $\mu$m aufweisen und auf Abstandshaltern 41 in einem Abstand von 50 $\mu$m zur Tragestruktur 36 gehalten werden. Die Abstandshalter 41 wiesen einen

Durchmesser von 140 $\mu$m auf. Der Abstand g benachbarter Spiegelkörper 35 betrug 35 $\mu$m. Diese Abmessungen entsprechen den tatsächlichen Gegebenheiten in einer entsprechenden Spiegel-Einrichtung. Sie sind nicht als einschränkend zu verstehen. Eine Anpassung der erfindungsgemäß vorgesehenen Abschirm-Elemente an alternative Ausführungsformen der Spiegel, insbesondere an Spiegelkörper mit einer Abmessung von 1 mm, ist problemlos möglich.

Zur Erzeugung des elektrischen Feldes 23 im Bereich zwischen den Seitenflächen 22 der Spiegelkörper 35 sind beim Ausführungsbeispiel gemäß Fig. 2 jeweils Abschirmelektroden 25 im Bereich der Seitenflächen 22 angeordnet. Die Abschirmelektroden 25 erstrecken sich jeweils im Wesentlichen über die gesamte Seitenfläche 22 des Spiegelkörpers 35, insbesondere über dessen gesamte Dicke d. Anderenfalls bezeichnet d in den vorhergehend aufgeführten Formeln für $U_r$ die Erstreckung der Abschirm-Elektroden 25 in Richtung der Dicken-Ausdehnung der Spiegelkörper 35.

Das Verhältnis der Fläche der Abschirmelektrode 25 zur Seitenfläche 22 des Spiegelkörpers 35 beträgt insbesondere mindestens 0,5, insbesondere mindestens 0,7, insbesondere mindestens 0,8, insbesondere mindestens 0,9, insbesondere mindestens 0,95, insbesondere mindestens 0,99.

Zur Beaufschlagung der Abschirm-Elektroden 25 mit einer Abschirmspannung $U_r$ ist eine Spannungsquelle 63 vorgesehen. Die Spannungsquelle 63 ist in den Figuren nur schematisch angedeutet. Sie kann Bestandteil der Vielspiegel-Anordnung 29 sein. Sie kann insbesondere im Bereich der Tragestruktur 36 angeordnet sein. Es kann sich auch um eine externe Spannungsquelle handeln.

Die Spannungsquelle 63 ist über elektrische Zuleitungen 64 mit den Abschirm-Elektroden 25 verbunden. Die elektrischen Zuleitungen 64 sind zumindest abschnittsweise im Spiegelkörper 35 und in der Tragestruktur 36 angeordnet.

In der Fig. 3A ist der Fall dargestellt, dass die Kammelektroden 24 benachbarter Einzelspiegel 27 derart aktiviert werden, dass das von ihnen erzeugte elektrische Feld im Wesentlichen entgegengerichtet zum elektrischen Feld 23 zwischen den Seitenflächen 22 der jeweiligen Spiegelkörper 35 ausgerichtet ist. In der Fig. 3B ist der Fall dargestellt, dass das von den Kammelektroden 24 erzeugte elektrische Feld in die gleiche Richtung zeigt wie das von den Abschirm-Elektroden 25 erzeugte elektrische Feld 23 im Bereich zwischen den Seitenflächen 22 der entsprechenden Spiegelkörper 35.

Wie aus den Fig. 3A und 3B qualitativ ersichtlich ist, hat das von den Kammelektroden 24 erzeugte elektrische Feld unter den angegebenen Bedingungen einen allenfalls vernachlässigbaren Einfluss auf die Verteilung der elektrischen Feldstärke im elektrischen Feld 23 im Bereich zwischen den Seitenflächen 22 der benachbarten Einzelspiegel 27. Das elektrische Feld 23 in diesem Bereich wird von der an die Abschirmelektroden 25 angelegten Spannung $U_r$ dominiert. Eine Abschirmspannung $U_r$ von 80 V führt zu einer vollständigen elektrischen Abschirmung des Volumenbereichs hinter der Rückseite 21 der Einzelspiegel 27. Das von den Abschirmelektroden 25 erzeugte elektrische Feld 23 ist im Wesentlichen auf den Bereich zwischen den Seitenflächen 22 der benachbarten Einzelspiegel 27 begrenzt. Durch Anlegen der Abschirmspannung $U_r$ wird ein Plateau von parallelen Äquipotenziallinien erzeugt. Das elektrische Feld 23 kann mit anderen Worten als uniform und parallel zu den Reflexionsflächen 34 der Einzelspiegel 27 angesehen werden. Zwar kann das in den Bereich vor der Vorderseite der Spiegelkörper 35 hineinreichende elektrische Feld 23 zu einer Beeinflussung geladener Teilchen in diesem Bereich führen, jedoch wird dies nicht zu einer signifikanten Zunahme deren kinetischer Energie führen. Die in den Fig. 3A und 3B exemplarisch dargestellten Situationen führen mit anderen Worten zu keiner Leckage des Plasmas 45 zu den Kammelektroden 24 sowie allgemein in den Bereich hinter der Rückseite 21 der Spiegelkörper 35.

Weiter konnte gezeigt werden, dass dies auch für den Fall gilt, dass einer oder beide der benachbarten Einzelspiegel 27 in einer verschwenkten Position, insbesondere in der maximal verschwenkten Position, sind.

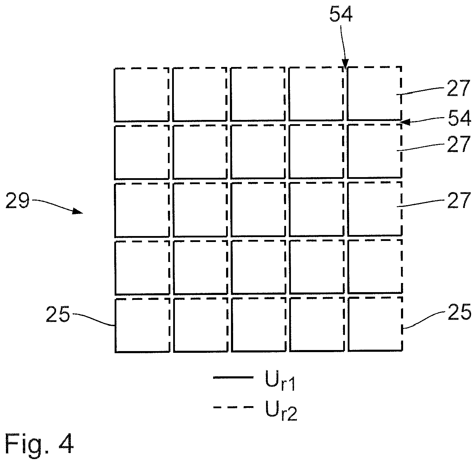

Im Folgenden werden unter Bezugnahme auf die Fig. 4 weitere Details der Abschirm-Elemente, insbesondere der Anordnung der Abschirm-Elektroden 25 in der Vielspiegel-Anordnung 29 beschrieben.

In Fig. 4 ist exemplarisch eine Anordnung der Einzelspiegel 27 in der Vielspiegel-Anordnung 29 gezeigt, bei welcher die Abschirmelektroden 25 derart im Bereich der Seitenflächen 22 der Spiegelkörper 35 der Einzelspiegel 27 angeordnet sind, dass zwischen sämtlichen benachbarten Einzelspiegeln 27 jeweils ein elektrisches Feld 23 zur Abschirmung des Plasmas 25 erzeugbar ist.

Die Abschirmelektroden 25 sind jeweils paarweise im Bereich einander gegenüberliegender Seitenflächen 22 benachbarter Einzelspiegel 27 angeordnet. Sie dienen jeweils dem Aufbau des elektrischen Feldes 23 im Bereich zwischen den benachbarten Einzelspiegeln 27.

In der Fig. 4 ist schematisch angedeutet, dass die Abschirmelektroden 25 mit unterschiedlichen Spannungen $U_r$ beaufschlagt werden. Eine erste Teilmenge der Abschirmelektroden 25 wird mit einer ersten Spannung $U_{r1}$ beaufschlagt. Eine zweite Teilmenge der Abschirmelektroden 25 wird mit einer zweiten Spannung $U_{r2}$ beaufschlagt. Hierbei gilt: $U_{r1} \neq U_{r2}$, insbesondere $|U_{r1} - U_{r2}| \geq 10$ V, insbesondere $|U_{r1} - U_{r2}| \geq 20$ V, insbesondere $|U_{r1} - U_{r2}| \geq 30$ V, insbesondere $|U_{r1} - U_{r2}| \geq 40$ V, insbesondere $|U_{r1} - U_{r2}| \geq 50$ V, insbesondere $|U_{r1} - U_{r2}| \geq 70$ V, insbesondere $|U_{r1} - U_{r2}| \geq 100$ V. Es gilt insbesondere: $|U_{r1} - U_{r2}| \leq 300$ V, insbesondere $|U_{r1} - U_{r2}| \leq 200$ V, insbesondere $|U_{r1} - U_{r2}| \leq 100$ V.

Bei der Anordnung gemäß Fig. 4 sind jeweils zwei Abschirmelektroden 25 in aneinandergrenzenden Seitenflächen 22 des Spiegelkörpers 35 äquipotenzial, das heißt sie werden mit den gleichen Abschirmpotenzial beaufschlagt.

Bei der Anordnung gemäß Fig. 4 ist die Beaufschlagung der Abschirmelektroden 25 mit elektrischer Spannung gerade so gewählt, dass sämtliche Einzelspiegel 27 dieselbe Anordnung von Abschirmelektroden 25 mit bestimmten Abschirmpotenzialen aufweisen. Konkret weisen jeweils die in der Fig. 4 nach unten und nach links weisenden Abschirmelektroden 25 der Einzelspiegel ein erstes Potenzial $U_{r1}$ auf. Die nach oben und nach rechts weisenden Abschirm-Elektroden 25 werden jeweils auf einem zweiten Potenzial $U_{r2} \neq U_{r1}$ gehalten. Gemäß einer bevorzugten Ausführungsform weisen die unterschiedlichen Abschirmpotentiale die gleiche Amplitude jedoch umgekehrte Polarität auf: $U_{r1} = -U_{r2}$.

Andere Anordnungen der Einzelspiegel 27, das heißt der Abschirmpotenziale, mit welchen die Abschirmelektroden 25 jeweils beaufschlagt werden, sind ebenso möglich. Beispielsweise ist es ausgehend von der Anordnung gemäß Fig. 4 möglich, jeden Einzelspiegel 27 der zweiten, vierten, sechsten, ... (2n)-ten Reihe um 90° im Gegenuhrzeigersinn zu drehen. Ebenso ist es möglich, jeden Einzelspiegel 27 der zweiten, vierten, sechsten, ...(2n)-ten Spalte um 90° im Uhrzeigersinn zu drehen.

Außerdem ist es möglich, jeweils die einander gegenüberliegenden Abschirmelektroden 25 jedes der Einzelspiegel 27 mit demselben Abschirmpotenzial zu beaufschlagen. In diesem Fall werden benachbarte Einzelspiegel 27 einer Zeile beziehungsweise Spalte jeweils um 90° zueinander verdreht angeordnet.

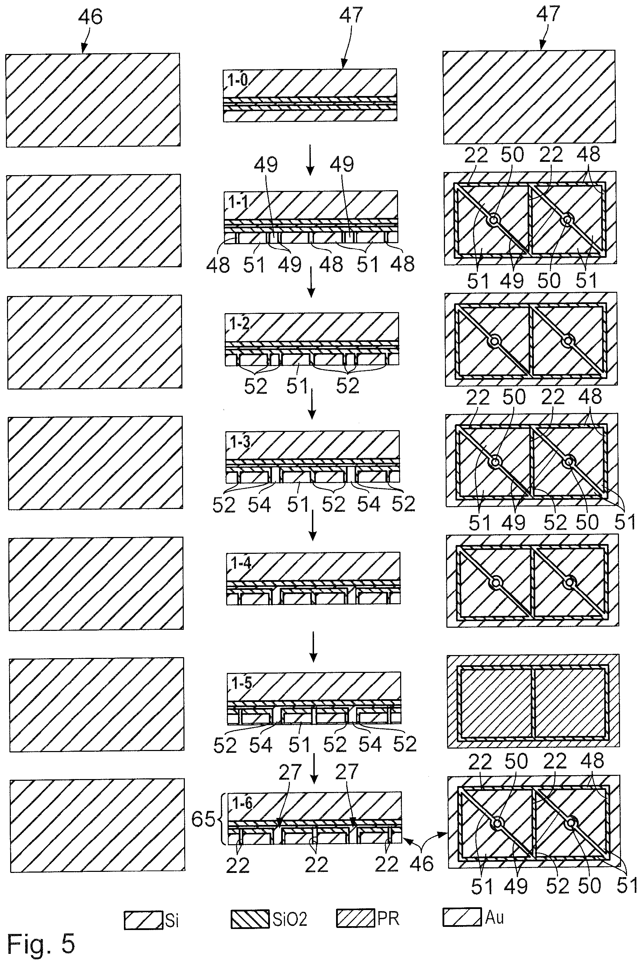

Welche Anordnung ausgewählt wird, hängt von der elektrischen Architektur, der möglichen Anordnung der Abschirmkabel und der Zuleitungen ab. Im Folgenden werden unter Bezugnahme auf die Fig. 5 bis 12 Verfahren zur Herstellung der Vielspiegel-Anordnung 29 beschrieben. In den Figuren ist jeweils nur ein Ausschnitt mit zwei Einzelspiegeln 27 der Vielspiegel-Anordnung 29 dargestellt. Die gesamte Vielspiegel-Anordnung 29 kann wesentlich größer sein. Sie kann insbesondere eine Vielzahl von Zeilen und Spalten mit Einzelspiegeln 27 umfassen. In den Figuren sind jeweils Ansichten von oben (linke Spalte), Schnittansichten (mittlere Spalte) und Ansichten von unten (rechte Spalte) von Zwischenprodukten nach einzelnen, unterschiedlichen Verfahrensschritten exemplarisch dargestellt. In den Figuren sind unterschiedliche Materialien durch unterschiedliche Schraffuren dargestellt.

Die Figuren zeigen eine mögliche Abfolge von Verfahrensschritten zur Herstellung einer MEMS Vielspiegel-Anordnung 29, welche zum Einsatz in einer Plasmaumgebung geeignet ist. Eine notwendige Voraussetzung hierfür ist, dass die internen elektrischen Bauteile, insbesondere Schaltkreise, Aktuatoren, Sensoren sowie insbesondere ASICs ungestört funktionieren. Sie müssen insbesondere gegen freie Ladungen aus der Plasmaumgebung geschützt werden.

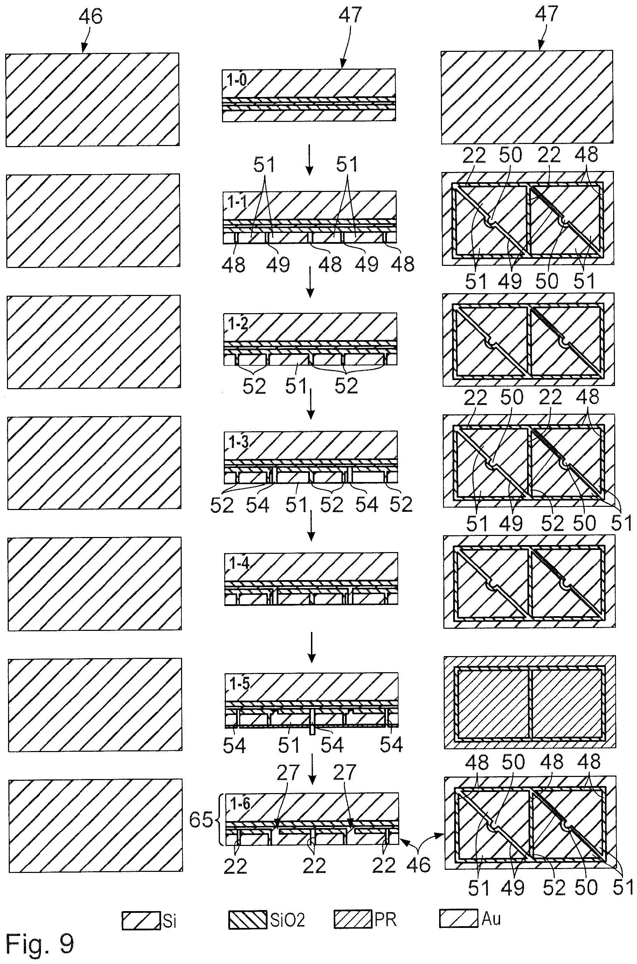

Die Fig. 5 bis 8 zeigen die Abfolge von Verfahrensschritten zur Herstellung einer Vielspiegel-Anordnung 29, bei welcher drei unterschiedliche elektrische Potenziale an die Reflexionsfläche 34 sowie jeweils zwei Paare aneinandergrenzender Seitenflächen 22 angelegt werden. Die Fig. 5 bis 8 zeigen exemplarisch die Abfolge von Verfahrensschritten zur Herstellung einer Vielspiegel-Anordnung 29, welcher derart ausgebildet ist, dass die Vorderseite des Einzelspiegels 27 und jeweils zwei Paare jeweils aneinandergrenzender Seitenflächen 22 jeweils mit unterschiedlichen Spannungen beaufschlagbar sind. Die Fig. 9 bis 12 zeigen eine Alternative, bei welcher die Vorderseite des Einzelspiegels 27 mit demselben Potenzial beaufschlagt wird wie ein Paar der Seitenflächen 22. Die Abfolge der Verfahrensschritte ist im Wesentlichen identisch und wird daher für beide Alternativen zusammen beschrieben. Auf Unterschiede wird gegebenenfalls hingewiesen.

Zunächst wird unter Bezugnahme auf die Fig. 5 und 9 die Herstellung eines Spiegel-Wafers 46 beschrieben. Zur Herstellung des Spiegel-Wafers 46 werden zunächst doppelte SOI-Wafer 47 (Silicon-on-Isolator-Wafer; Silizium auf Isolator-Wafer) bereitgestellt (1-0). Die Dotierung der SOI-Wafer 47 hängt vom gewünschten elektrischen Widerstand der Spiegel ab. Sie kann je nach Bedarf geeignet gewählt werden.

In einem ersten Verfahrensschritt (1-1) werden die Umrandung der Spiegel 48 sowie diagonale Einschnitte 49 definiert. Die diagonalen Einschnitte 49 teilen die Spiegelplatte in drei Teile: ein zylindrisches Volumen 50, welches der Ausbildung eines elektrischen Kontakts zur Spiegelfläche dient, sowie zwei dreieckige Teile 51. Die beiden dreieckigen Teile 51 weisen jeweils zwei aneinandergrenzende Seitenflächen 22 auf.

Bei der Variante gemäß Fig. 9 ist das zylindrische Volumen 50 nicht vollständig separiert, sondern hängt mit einem der dreieckigen Teile 51 zusammen.

Sodann ist eine lithografische Gestaltung zur Mikrostrukturierung der SOI-Wafer 47 mit einem vertikalen Profil vorgesehen. Die lithografische Gestaltung wird von einem DRIE (Deep Reactive Ion Etching, reaktives Ionentiefenätzen) gefolgt. Hierbei werden die richtigen Ätzgase geeignet ausgewählt und es wird in einer vorgegebenen Sequenz mehrfach geätzt und passiviert (so genannter Bosch Prozess).

Für einen derartigen DRIE-Prozess kann ein ICP-Ätzer (Inductively Coupled Plasma Etcher; induktiv gekoppelter Plasmaätzer) mit $SF_6$ als Ätzgas und $CHF_3$ oder $C_4F_8$ als Polymer-formendes Gas vorgesehen sein.

Sodann (1-2) werden die geätzen Einschnitte 49 aufgefüllt. Hierfür kann eine TEOS-$SiO_2$ (Tetraethylorthosilikat)-Methode verwendet werden. Diese dient dazu, $SiO_2$-Schichten 52 schnell, insbesondere mit einer Rate im Bereich von 25 nm/min bis 100 nm/min, abzuscheiden. Die Temperatur liegt hierbei im Bereich von 600°C bis 800°C.

Die Rückseite der SOI-Wafer 47 kann daraufhin poliert werden.

Sodann ist vorgesehen, eine Kontaktfläche zur Spiegeloberfläche herzustellen. Hierfür ist ein Lithographieschritt vorgesehen. Es ist insbesondere vorgesehen, eine Ausnehmung, insbesondere eine kreisförmige Ausnehmung, im Photoresist im Bereich des Spiegelzentrums herzustellen. Sodann wird ein vertikales Silizium-DRIE-Verfahren mit einem Ätzstopp auf dem zweiten verdeckten Oxid durchgeführt.

Bei der Alternative gemäß Fig. 5 ist der Ätzprozess seitlich durch den äußeren Siliziumdioxidhohlzylinder selbst begrenzt. Ein schnelles isotropes Silizium-Ätzen mit $SF_6$-Gas kann angewendet werden. Bei der Alternative gemäß Fig. 9 ist vorgesehen, ein sogenanntes Bosch-Verfahren, das heißt eine Sequenz von mehrfachen Ätz- und Passivierungsschritten anzuwenden.

Der Zugang zu der oberen Spiegellage wird vervollständigt durch Polymerpassivierung der $SiO_2$-Seitenwände und nachfolgendes anisotropes $SiO_2$-reaktives Ionenätzen (RIE) mit $CHF_3$ + Ar oder $CHF_3$ + $CF_4$-Gasen und Gasdruck. Größere Anisotropie des Ätzprozesses erreicht man mit höherem Wafer Bias, insbesondere einem Wafer Bias von mehr als 100 V. Die elektrische Verbindung zur oberen Lage des Spiegels wird vervollständigt durch Auffüllen der geätzten Strukturen mit dotiertem Poly-Silizium. Anschließend kann, sofern notwendig, eine Rückseitenpolierung vorgesehen sein (1-4).

Sodann werden die Zwischenräume 54 zwischen den Einzelspiegeln 27 geöffnet. Das aufgefüllte TEOS zwischen den Einzelspiegeln 27 kann hierfür chemisch in BHF (Buffered Hydrofluoric Acid, gepufferte Flusssäure) geätzt werden. Hierbei kann die restliche Waferoberfläche mit einer Photoresistmaske geschützt werden (1-5).

Als letzte Schritte bei der Herstellung des Spiegel-Wafers 46 werden die Seitenflächen 22 passiviert. Außerdem wird das Silizium zwischen den beiden vergrabenen Oxidschichten strukturiert. Hierfür dient ein DRIE Prozess. Der Prozess stoppt automatisch, wenn die obere Oxidschicht erreicht wird. Am Ende wird der Photoresist entfernt. Der fertige Spiegel-Wafer 46 weist dreilagige Spiegelplatten 65 auf (1-6).

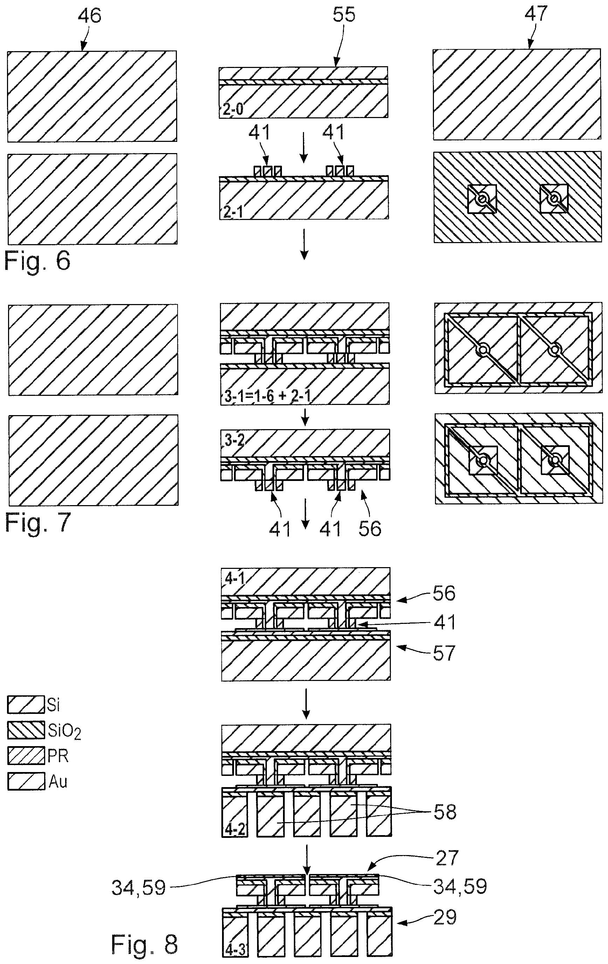

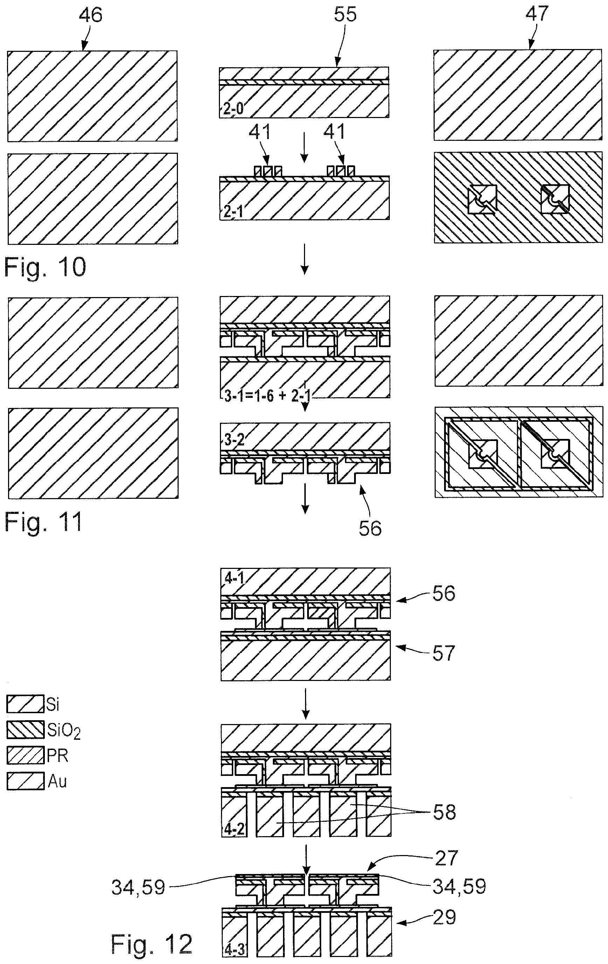

Anhand der Fig. 6 und 10 wird die Herstellung der Abstandshalter 41 erläutert. Zur Herstellung der Abstandshalter 41 wird ein zweiter SOI-Wafer 55 bereitgestellt (2-0). Der zweite SOI-Wafer 55 wird mittels eines DRIE-Verfahrens strukturiert (2-1). Hierbei kann ein zweiteiliger (Fig. 10) oder ein dreiteiliger (Fig. 6) Abstandshalter 41 hergestellt werden.

Der Abstandshalter 41 erlaubt die Anordnung der Spiegelkörper 35 oberhalb ihrer Aufhängung. Dieses Design der Spiegelkörper 35 auf den Abstandshaltern 41 ermöglicht es, die Spiegel 27 mit Hilfe von integrierten Mikro-Aktuatoren zu verschwenken, insbesondere mit zwei Schwenkfreiheitsgraden.

Zusätzlich zur mechanischen Funktion haben die Abstandshalter 41 die Aufgabe, die elektrischen Verbindungen zu den Spiegelkörpern 35 aufzunehmen.

Anhand der Fig. 7 und 11 wird die Herstellung eines zusammengesetzten Spiegel-Wafers 56 (Composite Mirror Wafer) erläutert. Zur Herstellung des zusammengesetzten Spiegel-Wafers 56 wird der Spiegel-Wafer 46 mit dem strukturierten zweiten SOI-Wafer 55 mit den Abstandshaltern 41 verbunden. Hierfür kann ein direktes oder ein eutektisches Bonding-Verfahren vorgesehen sein (3-1). Anschließend werden der Haltewafer und das verdeckte Oxid des zweiten SOI-Wafers 55 entfernt. Hierfür kann ein nachfolgendes Silizium und Siliziumdioxid-Ätzen vorgesehen sein. Zum isotropen Ätzen von Silizium kann beispielsweise $SF_6$ oder $XeF_2$ Plasma vorgesehen sein. Zur Ätzung des verdeckten Oxids kann $CHF_3$/$CF_4$-Plasma oder HF-Säure-Dampf vorgesehen sein.

Die derart hergestellten zusammengesetzten Spiegel können in bekannten Verfahrensabläufen weiterverarbeitet werden. Wie in den Fig. 8 und 12 schematisch und exemplarisch dargestellt ist, kann der zusammengesetzte Spiegelwafer 56 mit einem Aktuatorwafer 57 verbunden werden. Der Aktuatorwafer 57 umfasst integrierte Aktuatoren. Er kann auch Sensoren, insbesondere zur Erfassung der Verlagerungsposition der Einzelspiegel 27, umfassen. In einem Ätzschritt (4-2) werden die zentralen Elektroden 58 ausgehend von der Rückseite des Aktuatorwafers 57 freigeätzt.

Sodann wird die Spiegeloberfläche freigelegt (4-3). Hierfür ist ein aufeinanderfolgendes Ätzen des obengelegenen Haltewafers und der verdeckten $SiO_2$-Schicht, welcher Bestandteil des SOI-Wafers 47 war, vorgesehen.

Schließlich wird eine EUV-reflektierende Beschichtung 59 auf die Spiegeloberfläche abgeschieden, um die Reflexionsflächen 34 der Einzelspiegel 27 herzustellen. Die Spiegeloberfläche weist hierbei eine Sub-Nanometerrauigkeit auf. Sie wird während des gesamten Herstellungsprozesses bis zum Zeitpunkt der Abscheidung der EUV-reflektierenden Beschichtung vor Defekten und Kontamination durch die verdeckte Oxidschicht des doppelten SOI-Wafers 47 geschützt.

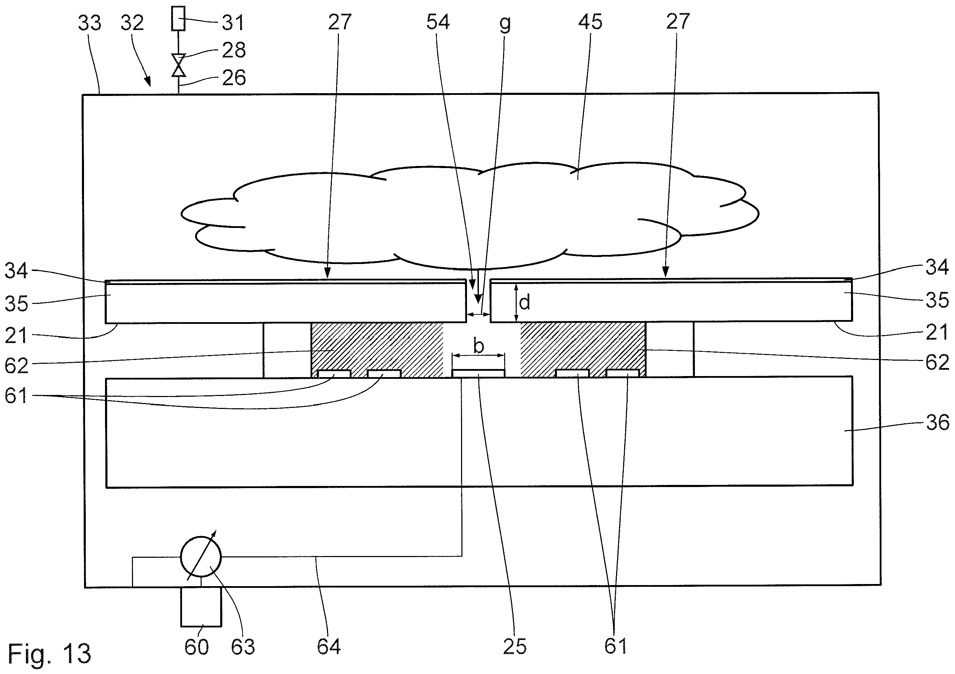

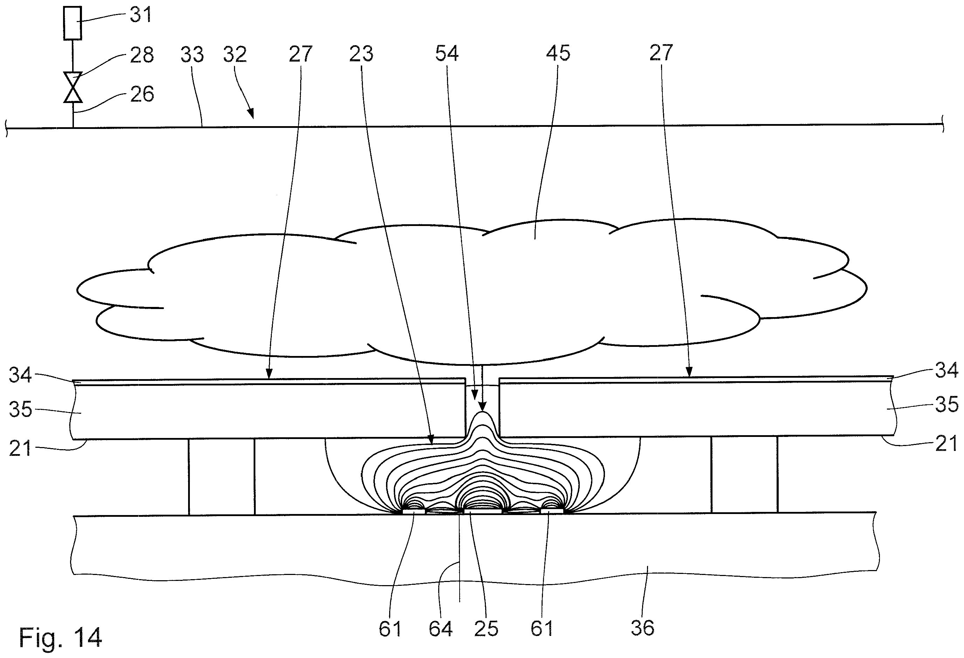

Im Folgenden wird unter Bezugnahme auf die Fig. 13 und 14 eine alternative Ausführungsform der Vielspiegel-Anordnung 29 mit Abschirm-Elementen beschrieben. Identische Teile erhalten dieselben Bezugszeichen wie bei den vorhergehend beschriebenen Ausführungsbeispielen, auf die hiermit verwiesen wird. Bei der Ausführungsform gemäß den Fig. 13 und 14 sind die Abschirm-Elektroden 25 im Bereich hinter der Rückseite 21 der Einzelspiegel 27 angeordnet. Die Abschirm-Elektroden 25 sind insbesondere auf der Tragestruktur 36 angeordnet. Sie können insbesondere als Abschirmdrähte ausgebildet sein.

Die Abschirm-Elektroden 25 sind insbesondere im Bereich hinter dem Zwischenraum zwischen zwei benachbarten Spiegeln 27 angeordnet.

Sie können jeweils eine Breite b aufweisen, welche größer ist als der Abstand g zwischen benachbarten Einzelspiegeln 27. Hierdurch kann eine Leckage des Plasmas besonders wirksam verhindert werden. Es gilt insbesondere: $b : g \geq 0{,}5$, insbesondere $b : g \geq 0{,}7$, insbesondere $b : g \geq 1{,}5$, insbesondere $b : g \geq 2$, insbesondere $b : g \geq 3$. Die Breite b der Abschirm-elektroden 25 ist im Wesentlichen durch den vorhandenen Bauraum und den funktionalen Sicherheitsabstand zur Vermeidung elektrischer Überschläge zu benachbarten Leitungen begrenzt.

Die Abschirm-Elektroden 25 werden auch als aktive Drähte (active wires) bezeichnet. Sie können den Volumenbereich hinter der Rückseite der Einzelspiegel 27 sowie insbesondere die darin angeordneten elektronischen Bauteile vor freien Ladungen schützen. Sie können insbesondere die Diffusion freier Ladungen in diesem Volumenbereich verhindern. Die Abschirm-Elektroden 25 sind insbesondere mittels einer Steuereinrichtung 60 mit einer steuerbaren elektrischen Spannung beaufschlagbar. Die Abschirmspannung, mit welcher die Abschirm-Elektroden 25 beaufschlagt werden, ist insbesondere an die Spiegelgeometrie sowie an die zu erwartende Energie der freien Ladungsträger im Bereich vor der Vorderseite der Spiegel 27 anpassbar.

Die Abschirm-Elektroden 25 können mit einer positiven Abschirmspannung beaufschlagt werden. Sie dienen in diesem Fall als Attraktor für freie Elektronen sowie negativ geladene Ionen. Sie wirken in diesem Fall abstoßend auf positiv geladene Teilchen.

Die Abschirm-Elektroden 25 können auch mit einer negativen Spannung beaufschlagt werden. Sie wirken in diesem Fall abstoßend auf Elektronen und andere negativ geladene Teilchen und anziehend auf positiv geladene Teilchen.

Durch die Abschirm-Elektroden 25 lässt sich eine Störung der sensitiven elektronischen Bauteile 61 in einem vorgegebenen, abzuschirmenden Volumenbereich 62 wirksam verhindern.

Die abzuschirmenden sensitiven elektronischen Bauteile 61 sind in den Fig. 13 und 14 exemplarisch angedeutet. Es kann sich hierbei um sensitive Signal- und/oder Stromleitungen handeln. Es kann sich auch um komplexere elektronische Bauteile, beispielsweise ASICs, handeln.

Die Ausführung der Abschirm-Elemente als Abschirm-Elektroden 25, welche auf der Tragestruktur 36 angeordnet sind, ist besonders einfach realisierbar. Sie benötigt nur eine sehr geringe Leistungsaufnahme. Sie führt zu einer sehr zuverlässigen Abschirmung des abzuschirmenden Volumenbereichs 62.

Im Folgenden werden stichwortartig Alternativen und Weiterbildungen zu der in den Fig. 13 und 14 dargestellten Ausführungsform beschrieben.

Anstelle von einzelnen Abschirm-Elektroden 25 können die Abschirm-Elemente auch eine andere Ausbildung und/oder Struktur aufweisen. Sie können insbesondere jeweils zwei oder mehr Drähte, insbesondere parallel zueinander angeordnet Drähte, umfassen. Sie können auch durch ein Gitter gebildet sein. Bei diesen Alternativen ist es möglich, unterschiedliche Drähte und/oder unterschiedliche Bereiche des Gitters mit unterschiedlichen Spannungen zu beaufschlagen.

Die Abschirm-Elektroden 25 können eine Oberfläche aus Metall aufweisen. Sie können auch eine Oberfläche aus Poly-Silizium aufweisen.

Die Abschirm-Elemente können auch als Spulen oder spulenartige Strukturen ausgebildet sein. In diesem Fall kann insbesondere auch ein von den Abschirm-Elementen erzeugtes Magnetfeld zur Abschirmung des Volumenbereichs 62 genutzt werden.

Kombinationen der unterschiedlichen Alternativen der Abschirm-Elemente sind möglich.

**Patentansprüche**

1.   Spiegel-Einrichtung (29) umfassend

   1.1. mindestens einen Spiegel (27) mit einem Spiegel-Körper (35) mit

      1.1.1. einer nach vorne weisenden Vorderseite,
      1.1.2. einer Rückseite (21) und
      1.1.3. mindestens einer Seitenfläche (22), und

   1.2. mindestens zwei separate elektrisch leitfähige Abschirm-Elemente (25),

      1.2.1. welche mittels mindestens zweier elektrischer Zuleitungen (64) mit unterschiedlichen Spannungen $(U_{r1}, U_{r2})$ beaufschlagbar sind; und
      1.2.2. welche ein Mittel zur Erzeugung eines elektrischen Feldes in einem an die mindestens eine Seitenfläche (22) und/oder die Rückseite (21) angrenzenden Bereich bilden.

2.   Spiegel-Einrichtung (29) gemäß Anspruch 1, **dadurch gekennzeichnet, dass** mindestens eines der elektrisch leitfähigen Abschirm-Elemente (25) im Bereich der mindestens einen Seitenfläche (22) und/oder im Bereich auf oder hinter der Rückseite (21) des Spiegels (27) angeordnet ist.

3.   Spiegel-Einrichtung (29) gemäß einem der vorhergehenden Ansprüche, **gekennzeichnet durch** eine Spannungsquelle (63) zur Beaufschlagung mindestens eines der elektrisch leitfähigen Abschirm-Elemente (25) mit elektrischer Spannung im Bereich von -300 V bis 300 V.

**4.** Spiegel-Einrichtung (29) gemäß einem der vorhergehenden Ansprüche, **gekennzeichnet durch** eine Steuereinrichtung (60) zur Steuerung der elektrischen Spannung, mit welcher mindestens eines der elektrisch leitfähigen Abschirm-Elemente (25) beaufschlagt werden.

**5.** Spiegel-Einrichtung (29) gemäß einem der vorhergehenden Ansprüche, **dadurch gekennzeichnet, dass** die Abschirm-Elemente (25) über elektrische Zuleitungen im Spiegel-Körper (35) mit Spannungen ($U_{r1}$, $U_{r2}$) beaufschlagbar sind.

**6.** Spiegel-Einrichtung (29) gemäß einem der vorhergehenden Ansprüche, **dadurch gekennzeichnet, dass** mindestens zwei elektrisch leitfähige Abschirm-Elemente (25) in oder an unterschiedlichen Seitenflächen (22) eines der Spiegel-Körper (35) angeordnet sind.

**7.** Spiegel-Einrichtung (29) gemäß einem der vorhergehenden Ansprüche, **gekennzeichnet durch** eine Mehrzahl von Spiegeln (27) gemäß einem der vorhergehenden Ansprüche.

**8.** Spiegel-Einrichtung (29) gemäß Anspruch 7, **dadurch gekennzeichnet, dass** jeweils mindestens ein elektrisch leitfähiges Abschirm-Element (25) im Bereich hinter einem Zwischenraum zwischen zwei benachbarten Spiegeln (27) angeordnet ist.

**9.** Spiegel-Einrichtung (29) gemäß einem der Ansprüche 7 bis 8, **dadurch gekennzeichnet, dass** jeweils zwei elektrisch leitfähige Abschirm-Elemente (25) paarweise im Bereich einander gegenüberliegender Seitenflächen (22) benachbarter Spiegel (27) angeordnet sind.

**10.** Beleuchtungsoptik (4) für eine Projektionsbelichtungsanlage (1) umfassend mindestens eine Spiegel-Einrichtung (29) gemäß einem der Ansprüche 1 bis 9.

**11.** Beleuchtungssystem (2) für eine Projektionsbelichtungsanlage (1) für die Mikrolithographie umfassend

   11.1. eine Beleuchtungsoptik (4) gemäß Anspruch 10 und
   11.2. eine Strahlungsquelle (3) zur Erzeugung von Beleuchtungsstrahlung (10).

**12.** Projektionsbelichtungsanlage (1) für die Mikrolithographie umfassend

   12.1. eine Beleuchtungsoptik (4) gemäß Anspruch 10 und
   12.2. eine Projektionsoptik (7) zur Projektion der Beleuchtungsstrahlung (10) vom Objektfeld (5) in ein Bildfeld (8).

**13.** Verfahren zu Herstellung eines mikro- oder nanostrukturierten Bauelements

   13.1. Bereitstellung eines Retikels (30),
   13.2. Bereitstellung eines Wafers mit einer für die Beleuchtungsstrahlung (10) empfindlichen Beschichtung,
   13.3. Projizieren zumindest eines Abschnitts des Retikels (30) auf den Wafer mit Hilfe der Projektionsbelichtungsanlage (1) nach Anspruch 12,
   13.4. Entwickeln der mit der Beleuchtungsstrahlung (10) belichteten lichtempfindlichen Schicht auf dem Wafer.

**Claims**

**1.** Mirror device (29) comprising

   1.1. at least one mirror (27) with a mirror body (35) having

      1.1.1. a forward-facing front side,
      1.1.2. a rear side (21) and
      1.1.3. at least one side surface (22), and

   1.2. at least two separate electrically conductive shielding elements (25),

1.2.1. to which different voltages ($U_{r1}$, $U_{r2}$) can be applied by means of at least two electrical supply lines (64); and
1.2.2. which form a means for producing an electric field in a region adjacent to the at least one side surface (22) and/or the rear side (21) .

2. Mirror device (29) according to Claim 1, **characterized in that** at least one of the electrically conductive shielding elements (25) is arranged in the region of the at least one side surface (22) and/or in the region on or behind the rear side (21) of the mirror (27).

3. Mirror device (29) according to one of the preceding claims, **characterized by** a voltage source (63) for applying electrical voltage in the range of -300 V to 300 V to at least one of the electrically conductive shielding elements (25).

4. Mirror device (29) according to one of the preceding claims, **characterized by** a control device (60) for controlling the electrical voltage that is applied to at least one of the electrically conductive shielding elements (25).

5. Mirror device (29) according to one of the preceding claims, **characterized in that** voltages ($U_{r1}$, $U_{r2}$) can be applied to the shielding elements (25) by way of electrical supply lines in the mirror body (35).

6. Mirror device (29) according to one of the preceding claims, **characterized in that** at least two electrically conductive shielding elements (25) are arranged in or on different side surfaces (22) of one of the mirror bodies (35).

7. Mirror device (29) according to one of the preceding claims, **characterized by** a plurality of mirrors (27) according to one of the preceding claims.

8. Mirror device (29) according to Claim 7, **characterized in that** at least one electrically conductive shielding element (25) is respectively arranged in the region behind an interspace between two adjacent mirrors (27).

9. Mirror device (29) according to either of Claims 7 and 8, **characterized in that** two electrically conductive shielding elements (25) are respectively arranged in pairs in the region of mutually opposite side surfaces (22) of adjacent mirrors (27).

10. Illumination optical unit (4) for a projection exposure apparatus (1), comprising at least one mirror device (29) according to one of Claims 1 to 9.

11. Illumination system (2) for a microlithographic projection exposure apparatus (1) comprising

11.1. an illumination optical unit (4) according to Claim 10 and
11.2. a radiation source (3) for generating illumination radiation (10).

12. Microlithographic projection exposure apparatus (1) comprising

12.1. an illumination optical unit (4) according to Claim 10 and
12.2. a projection optical unit (7) for projecting the illumination radiation (10) from the object field (5) into an image field (8).

13. Method for producing a micro- or nanostructured component

13.1. providing a reticle (30),
13.2. providing a wafer having a coating that is sensitive to the illumination radiation (10),
13.3. projepcting at least one section of the reticle (30) onto the wafer with the aid of the projection exposure apparatus (1) according to Claim 12,
13.4. developing the light-sensitive layer on the wafer that has been exposed by the illumination radiation (10).

**Revendications**

1. Dispositif de miroirs (29), comprenant :

1.1 au moins un miroir (27) avec un corps de miroir (35), comportant

    1.1.1. une face avant dirigée vers l'avant,
    1.1.2. une face arrière (21) et
    1.1.3. au moins une surface latérale (22), et

1.2 au moins deux éléments boucliers (25) séparés, conducteurs d'électricité,

    1.2.1. lesquels, au moyen d'au moins deux conduits d'alimentation électrique (64) peuvent être soumis à différentes tensions ($U_{r1}$, $U_{r2}$) ; et
    1.2.2 lesquels forment un moyen destiné à créer un champ électrique dans une région adjacente à l'au moins une surface latérale (22) et/ou à la face arrière (21).

**2.** Dispositif de miroirs (29) selon la revendication 1, **caractérisé en ce qu'**au moins l'un des éléments boucliers (25) conducteurs d'électricité est placé dans la région de l'au moins une surface latérale (22) et/ou dans la région sur le dessus ou à l'arrière de la face arrière (21) du miroir (27).

**3.** Dispositif de miroirs (29) selon l'une quelconque des revendications précédentes, **caractérisé par** une source de tension (63), destinée à soumettre au moins l'un des éléments boucliers (25) conducteurs d'électricité à une tension électrique de l'ordre de - 300 V à 300 V.

**4.** Dispositif de miroirs (29) selon l'une quelconque des revendications précédentes, **caractérisé par** un système de commande (60), destiné à commander la tension électrique à laquelle est soumis au moins l'un des éléments boucliers (25) conducteurs d'électricité.

**5.** Dispositif de miroirs (29) selon l'une quelconque des revendications précédentes, **caractérisé en ce que** les éléments boucliers (25) peuvent être soumis à des tensions ($U_{r1}$, $U_{r2}$) via des conduits d'alimentation dans le corps de miroir (35).

**6.** Dispositif de miroirs (29) selon l'une quelconque des revendications précédentes, **caractérisé en ce qu'**au moins deux éléments boucliers (25) conducteurs d'électricité sont placés dans ou sur différentes surfaces latérales (22) de l'un des corps de miroir (35) .

**7.** Dispositif de miroirs (29) selon l'une quelconque des revendications précédentes, **caractérisé par** une pluralité de miroirs (27) selon l'une quelconque des revendications précédentes.

**8.** Dispositif de miroirs (29) selon la revendication 7, **caractérisé en ce que** chaque fois au moins un élément bouclier (25) conducteur d'électricité est placé dans la région située à l'arrière d'un espace intermédiaire entre deux miroirs (27) voisins.

**9.** Dispositif de miroirs (29) selon l'une quelconque des revendications 7 ou 8, **caractérisé en ce que** chaque fois deux éléments boucliers (25) conducteurs d'électricité sont placés par paires dans la région de surfaces latérales (22) opposées de miroirs (27) voisins.

**10.** Optique d'éclairage (4), destinée à une installation d'exposition par projection (1), comprenant au moins un dispositif de miroirs (29) selon l'une quelconque des revendications 1 à 9.

**11.** Système d'éclairage (2), destiné à une installation d'exposition par projection (1) dans le domaine de la micro-lithographie, comprenant

    11.1 une optique d'éclairage (4) selon la revendication 10 et
    11.2 une source de rayonnement (3), destinée à créer un rayonnement d'éclairage (10).

**12.** Installation d'exposition par projection (1), destinée à la micro-lithographie, comprenant

    12.1 une optique d'éclairage (4) selon la revendication 10 et
    12.2 une optique de projection (7), destinée à projeter le rayonnement d'éclairage (10) du champ de l'objet (5) dans un champ d'image (8).

**13.** Procédé, destiné à fabriquer un composant à microstructure ou à nanostructure, comprenant

13.1 la mise à disposition d'un réticule (30),
13.2 la mise à disposition d'une tranche de silicium dotée d'un revêtement sensible au rayonnement d'éclairage (10),
13.3 la projection d'au moins un segment du réticule (30) sur la tranche de silicium, à l'aide de l'installation d'exposition par projection (1) selon la revendication 12,
13.4 le développement de la couche photosensible irradiée avec le rayonnement d'éclairage (10) sur la tranche de silicium.

Fig. 1

Fig. 2

Fig. 3A

Fig. 3B

Fig. 4

Fig. 5

Fig. 6

Fig. 7

Si
SiO2
PR
Au

Fig. 8

Fig. 9

46

55

47

2-0

41 41

2-1

**Fig. 10**

3-1=1-6 + 2-1

3-2

**Fig. 11**

56

4-1

56

57

Si
SiO$_2$
PR
Au

58

4-2

27

34,59

34,59

29

**Fig. 12**

4-3

Fig. 13

EP 3 234 695 B1

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2009100856 A1
- DE 102013218748 A1
- EP 1225481 A
- WO 2010049076 A1
- WO 2010049976 A1